# EUROPEAN PATENT APPLICATION

(11) **EP 4 827 292 A1**
(43) Date of publication of application: **21.10.2026**
(21) Application number: 26163579.1
(22) Date of filing: 10.03.2026
(51) Int. Cl.: H10K 59/122, H10K 59/124, H10K 50/19

(54) **DISPLAY PANEL, ELECTRONIC APPARATUS INCLUDING THE DISPLAY PANEL, AND METHOD OF MANUFACTURING THE DISPLAY PANEL**

(30) Priority: 15.04.2025 KR 20250049143
(71) Applicant: Samsung Display Co., Ltd., Yongin-si, Gyeonggi-do 17113 (KR)
(72) Inventor: KIM, Eunah, 17113 Yongin-si (KR)
(74) Representative: Marks & Clerk LLP

(57) **Abstract**

Provided is a display panel including: a transistor; an organic insulating layer on the transistor and including a groove; an inorganic insulating layer on the organic insulating layer and including a tip extending toward a center of the groove; a first pixel electrode and a second pixel electrode, on the inorganic insulating layer; a first intermediate layer on the first pixel electrode; a second intermediate layer on the second pixel electrode; a dummy intermediate layer on the groove of the organic insulating layer and separated from the first intermediate layer and the second intermediate layer by the tip of the inorganic insulating layer and the groove of the organic insulating layer; an intermediate insulating layer on the dummy intermediate layer and in contact with each of the first intermediate layer and the second intermediate layer; and an opposite electrode on the first intermediate layer and the second intermediate layer.

## Description

### TECHNICAL FIELD

One or more aspects relate to a display panel, an electronic apparatus including the display panel, and a method of manufacturing the display panel.

### BACKGROUND

A display panel includes display elements, such as organic light-emitting diodes, and transistors on a substrate and operates by causing the display elements to emit light.

Each pixel of the display panel has a display element such as an organic light-emitting diode including an intermediate layer including an emission layer disposed between a pixel electrode and an opposite electrode. The display panel controls the emission or luminance level of each pixel through a transistor electrically connected to the pixel electrode. Some layers included in the intermediate layer of the display elements are commonly provided in a plurality of display elements.

### SUMMARY

One or more aspects include a display panel that implements a high-quality image, an electronic apparatus including the display panel, and a method of manufacturing the display panel. However, the aspects are examples and do not limit the scope of the disclosure.

Additional aspects will be set forth in part in the description which follows and, in part, will be apparent from the description, or may be learned by practice of the presented aspects of the disclosure.

According to one or more aspects, a display panel includes a transistor on a substrate, an organic insulating layer on the transistor and including a groove, an inorganic insulating layer on the organic insulating layer, the inorganic insulating layer including a tip extending toward a center of the groove, a first pixel electrode and a second pixel electrode, disposed on the inorganic insulating layer, a first intermediate layer on the first pixel electrode, a second intermediate layer on the second pixel electrode, a dummy intermediate layer in the groove of the organic insulating layer, the dummy intermediate layer separated from the first intermediate layer and the second intermediate layer, wherein the first intermediate layer, the second intermediate layer and the dummy intermediate layer have the same composition, an intermediate insulating layer on the dummy intermediate layer and in contact with each of the first intermediate layer and the second intermediate layer; and an opposite electrode on the first intermediate layer and the second intermediate layer.

In an aspect, the first intermediate layer may include a first-1 emission unit, a first charge generation layer, and a second-1 emission unit, and the first charge generation layer may be spaced apart from the opposite electrode by the intermediate insulating layer, in a region overlapping the groove of the organic insulating layer.

In an aspect, the intermediate insulating layer may be positioned between the first pixel electrode and the second pixel electrode.

In an aspect, at least a portion of the intermediate insulating layer may be disposed between the dummy intermediate layer and the tip of the inorganic insulating layer.

In an aspect, at least a portion of the intermediate insulating layer may be disposed between the dummy intermediate layer and a portion of the first intermediate layer disposed on the tip of the inorganic insulating layer.

In an aspect, the intermediate insulating layer may include a first intermediate insulating layer and a second intermediate insulating layer, wherein a cross-section, at least a portion of the first intermediate insulating layer is positioned between the first intermediate layer and the dummy intermediate layer, and in a cross-section, at least a portion of the second intermediate insulating layer is positioned between the second intermediate layer and the dummy intermediate layer, and the first intermediate insulating layer and the second intermediate insulating layer may be spaced apart from each other.

In an aspect, a distance between an upper surface of the substrate and an upper surface of the intermediate insulating layer may be greater than a distance between the upper surface of the substrate and an upper surface of the inorganic insulating layer.

In an aspect, the intermediate insulating layer may include an organic insulating material.

In an aspect, the intermediate insulating layer may further include a black material.

In an aspect, the display panel may further include a pixel-defining layer disposed on the first pixel electrode and the second pixel electrode, the pixel-defining layer including a first pixel opening exposing a portion of the first pixel electrode, a second pixel opening exposing a portion of the second pixel electrode, and a separator opening aligned with the groove of organic insulating layer.

In an aspect, the intermediate insulating layer may be arranged within the separator opening of the pixel-defining layer.

In an aspect, the tip of the inorganic insulating layer may protrude in a direction toward the center of the groove more than a side surface of the organic insulating layer defining the groove.

In an aspect, the opposite electrode may be in contact with the intermediate insulating layer.

In an aspect, the opposite electrode may include: a first opposite electrode disposed on the first intermediate layer; and a second opposite electrode disposed on the second intermediate layer, and the first opposite electrode and the second opposite electrode may be spaced apart from each other.

According to one or more aspects, a display panel includes a transistor on a substrate; an organic insulating layer on the transistor and including a groove; an inorganic insulating layer on the organic insulating layer, the inorganic insulating layer including a tip extending toward a center of the groove; a first pixel electrode and a second pixel electrode on the inorganic insulating layer; a first intermediate layer on the first pixel electrode; a second intermediate layer on the second pixel electrode; a dummy intermediate layer in the groove of the organic insulating layer, the dummy intermediate layer separated from the first intermediate layer and the second intermediate layer, the first intermediate layer, the second intermediate layer and the dummy intermediate layer having the same composition; a first opposite electrode disposed on the first intermediate layer; and a second opposite electrode disposed on the second intermediate layer and the second opposite electrode spaced apart from the first opposite electrode, wherein each of the first opposite electrode and the second opposite electrode may be spaced apart from the dummy intermediate layer.

According to one or more aspects, an electronic apparatus includes a display module including a display panel; a power module; a memory; and a processor configured to provide an image data signal and an input control signal to the display module, wherein the display panel may include a transistor on a substrate; an organic insulating layer on the transistor and including a groove; an inorganic insulating layer on the organic insulating layer, the inorganic insulating layer including a tip extending toward a center of the groove; a first pixel electrode and a second pixel electrode, disposed on the inorganic insulating layer; a first intermediate layer on the first pixel electrode; a second intermediate layer on the second pixel electrode; a dummy intermediate layer in the groove of the organic insulating layer, the dummy intermediate layer separated from the first intermediate layer and the second intermediate layer, the first intermediate layer, the second intermediate layer and the dummy intermediate layer having the same composition; an intermediate insulating layer on the dummy intermediate layer and in contact with each of the first intermediate layer and the second intermediate layer; and an opposite electrode on the first intermediate layer and the second intermediate layer.

In an aspect, the first intermediate layer may include a first-1 emission unit, a first charge generation layer, and a second-1 emission unit, and the first charge generation layer may be spaced apart from the opposite electrode by the intermediate insulating layer, in a region overlapping the groove of the organic insulating layer.

According to one or more aspects, a method of manufacturing a display panel includes forming an organic insulating layer on a transistor; forming an inorganic insulating layer on the organic insulating layer, the inorganic insulating layer including a first opening; removing a portion of the organic insulating layer, in a region overlapping the first opening of the inorganic insulating layer, to form a groove of the organic insulating layer and a tip of the inorganic insulating layer; forming a pixel electrode on the inorganic insulating layer; disposing an intermediate layer on the pixel electrode and on the groove so that the tip of the inorganic insulating layer and the groove of the organic insulating layer separates the intermediate layer to form a dummy intermediate layer in the groove, the intermediate layer including a first emission unit, a charge generation layer, and a second emission unit; forming an intermediate insulating layer on the dummy intermediate layer; and forming an opposite electrode on the intermediate layer.

In an aspect, after forming the opposite electrode, the charge generation layer may be spaced apart from the opposite electrode by the intermediate insulating layer, in a region overlapping the groove of the organic insulating layer.

In an aspect, the method of manufacturing the display panel may further include forming a pixel-defining layer disposed on the pixel electrode, the pixel-defining layer including a pixel opening exposing a portion of the pixel electrode and a separator opening connected to the first opening of the inorganic insulating layer and exposing the tip of the inorganic insulating layer.

In an aspect, the intermediate insulating layer may include an organic insulating material.

In an aspect, the intermediate insulating layer may include a black organic insulating material.

At least some of the above and other features of the invention are set out in the claims.

### BRIEF DESCRIPTION OF THE DRAWINGS

The above and other aspects, features, and advantages of certain aspects of the disclosure will be more apparent from the following description taken in conjunction with the accompanying drawings, in which:
FIG. 1A is a block diagram of an electronic apparatus according to an aspect;
FIG. 1B are schematic views of electronic apparatuses according to various aspects;
FIG. 2 is a schematic plan view of a display panel according to an aspect;
FIG. 3A is a schematic plan view of a portion of a display panel according to an aspect;
FIG. 3B is a schematic plan view of a portion of a display panel according to an aspect;
FIG. 4 is a schematic cross-sectional view of a display element according to an aspect;
FIG. 5 is a schematic cross-sectional view of a display panel according to an aspect, taken along line I-I' of FIG. 3A;
FIG. 6 is a schematic cross-sectional view of a display panel according to an aspect, taken along line I-I' of FIG. 3A;
FIG. 7 is a schematic cross-sectional view of a display panel according to an aspect, taken along line I-I' of FIG. 3A;
FIG. 8 is a schematic cross-sectional view of a display panel according to an aspect, taken along line I-I' of FIG. 3A;
FIG. 9 is a schematic cross-sectional view of a display panel according to an aspect, taken along line I-I' of FIG. 3A; and
FIGS. 10 to 17 are sequential cross-sectional views illustrating a method of manufacturing a display panel, according to an aspect.

### DETAILED DESCRIPTION

Reference will now be made in detail to aspects, examples of which are illustrated in the accompanying drawings, wherein like reference numerals refer to like elements throughout. In this regard, the present aspects may have different forms and should not be construed as being limited to the descriptions set forth herein. Accordingly, the aspects are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

In the following aspects, the terms "first," "second," etc. are not used in a limiting sense but are used to distinguish one component from another.

According to aspects, an x-axis, a y-axis, and a z-axis are not limited to three axes on an orthogonal coordinate system, but may be interpreted in a broad sense including the three axes. For example, the x-axis, the y-axis, and the z-axis may be perpendicular to one another, or may represent different directions that are not perpendicular to one another.

Herein, singular expressions include plural expressions, unless the context clearly dictates otherwise.

In the following aspects, terms such as "comprise," "include," or "have" mean that a feature or component described in the specification is present, and do not exclude the possibility that one or more other features or components may be added.

Herein, when a part of a film, area, element, or the like is disposed over or on another part, it refers not only to a case where the part is directly on top of the other part, but also a case where another film, area, element, or the like is located therebetween.

In the drawings, for convenience of description, the sizes of elements may be exaggerated or reduced. For example, the size and thickness of each element shown in the drawings are shown arbitrarily for convenience of description, and thus, one or more aspects are not necessarily limited to those shown.

In some aspects, in which the implementation is otherwise feasible, specific process sequences may be performed in a different order than described. For example, two processes described in succession may be performed substantially at the same time, or may be performed in an order opposite to that in which they are described.

In the following aspects, it will be understood that when a layer, an area, or an element, etc. is referred to as being connected to another layer, area, or element, it may be directly or indirectly connected to the other layer, area, or element. For example, it will be understood in this specification that when a layer, an area, or an element is referred to as being in contact with or electrically connected to another layer, area, or element, it may be directly or indirectly in contact with or electrically connected to the other layer, area, or element.

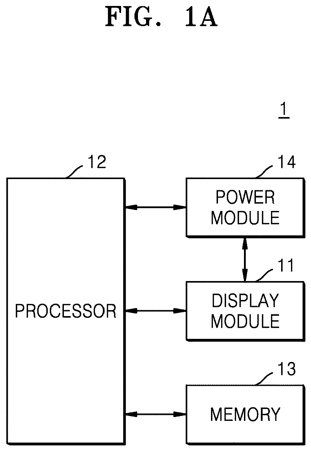

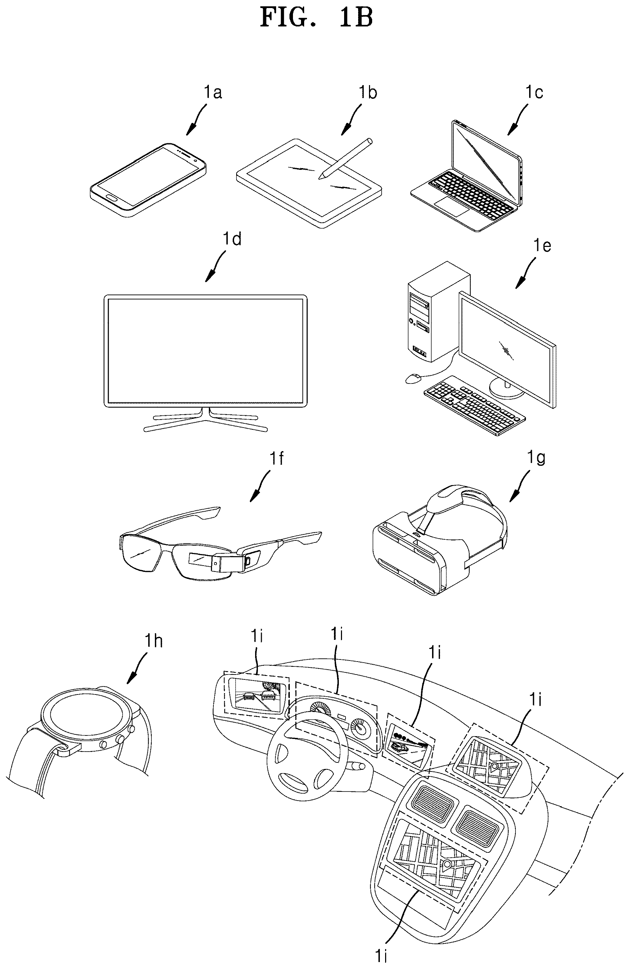

FIG. 1A is a block diagram of an electronic apparatus 1 according to an aspect. FIG. 1B are schematic views of electronic apparatuses according to various aspects.

Referring to FIG. 1A, an electronic apparatus 1 according to an aspect may include a display module 11, a processor 12, a memory 13, and a power module 14.

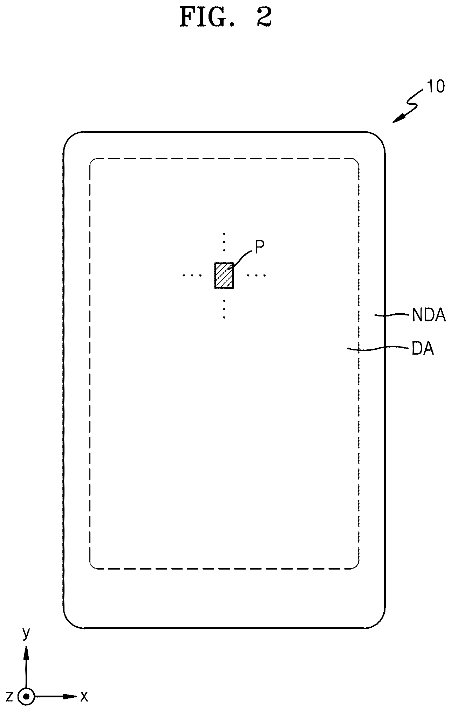

The display module 11 may include a display panel 10 (see FIGS. 2 to 3B and FIGS. 5 to 9) according to an aspect.

The processor 12 may include at least one of a central processing unit (CPU), an application processor (AP), a graphic processing unit (GPU), a communication processor (CP), an image signal processor (ISP), or a controller.

The memory 13 may store data information necessary for the operation of the processor 12 or the display module 11. When the processor 12 executes an application stored in the memory 13, an image data signal and/or an input control signal may be transmitted to the display module 11, and the display module 11 may process the received signal and output image information through a display screen.

The power module 14 may include a power supply module, such as a power adapter or a battery device, and a power conversion module that converts power supplied by the power supply module to generate power required for the operation of the electronic apparatus 1.

At least one of the components of the electronic apparatus 1 described above may be included in the display apparatus including the display module 11. Additionally, some of the individual modules functionally included within a module may be included in the display apparatus, while others may be provided separately from the display apparatus. For example, the display apparatus may include the display module 11, and the processor 12, the memory 13 and the power module 14 may be provided in the form of other apparatuses within the electronic apparatus 1 other than the display apparatus.

Referring to FIG. 1B, various electronic apparatuses including the display panel 10 (see FIGS. 2 to 3B and FIGS. 5 to 9) according to an aspect may include not only an image display electronic apparatus such as a smartphone 1a, a tablet PC 1b, a laptop 1c, a TV 1d, a desk monitor 1e, but also a wearable electronic apparatus including a display module such as smart glasses 1f, a head mounted display 1g, a smart watch 1h, or the like, and a vehicle electronic apparatus 1i including a display module such as a dashboard, a center fascia, a CID (Center Information Display) disposed on the dashboard, a room mirror display, or the like.

FIG. 2 is a schematic plan view of the display panel 10 according to an aspect.

Referring to FIG. 2, the display panel 10 may include a display area DA and a non-display area NDA located outside the display area DA.

The display area DA may display an image through pixels P arranged in the display area DA. Each pixel P may include a display element, such as a light-emitting diode. Each pixel P may emit light of, for example, red, green, blue or white.

The non-display area NDA may be located outside the display area DA and may not display an image, and may surround the display area DA. A driver or the like that provides electrical signals or power to the display area DA may be arranged in the non-display area NDA. A pad may be located in the non-display area NDA. The pad may be electrically connected to electronic components or printed circuit boards.

As shown in FIG. 2, in an aspect, the display area DA may be a polygon (e.g., a rectangle) where a length in the first direction (e.g., x direction) is smaller than a length in the second direction (e.g., y direction). However, the aspect is not limited thereto. In another aspect, the display area DA may be a polygon (e.g., a rectangle) where the length in the second direction (e.g., y direction) is smaller than the length in the first direction (e.g., x direction). FIG. 2 illustrates that the display area DA is approximately square, but the aspect is not limited thereto. In an aspect, the display area DA may have various shapes, such as an N-gon (N is a natural number greater than or equal to 3), a circle, or an ellipse. As illustrated in FIG. 2, the display area DA may be a polygon with rounded corners, but in another aspect, corners of the display area DA may have a shape including vertices where straight lines intersect.

The display panel 10 may include the light-emitting diode as the display element, and the light-emitting diode may be an organic light-emitting diode including an organic emission layer. Alternatively, the light-emitting diode may be an inorganic light-emitting diode including an inorganic emission layer. The size of the light-emitting diode may be micro-scale or nano-scale. For example, the light-emitting diode may be a micro light-emitting diode. Alternatively, the light-emitting diode may be a quantum dot light emitting diode including a quantum dot emission layer.

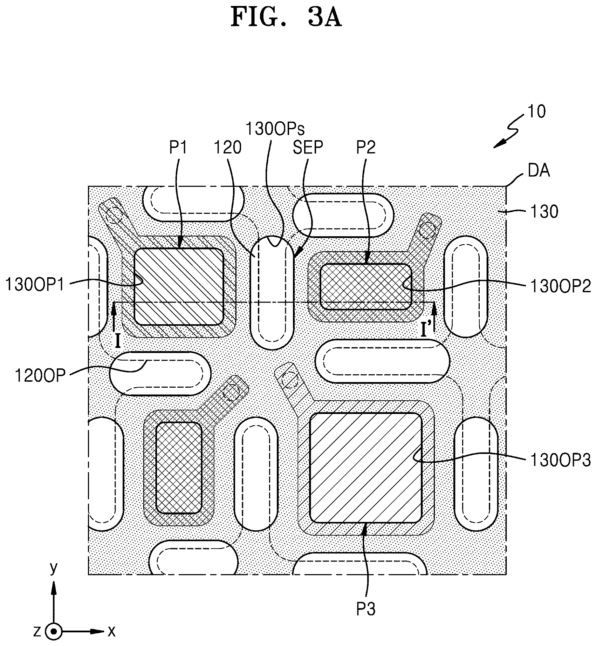

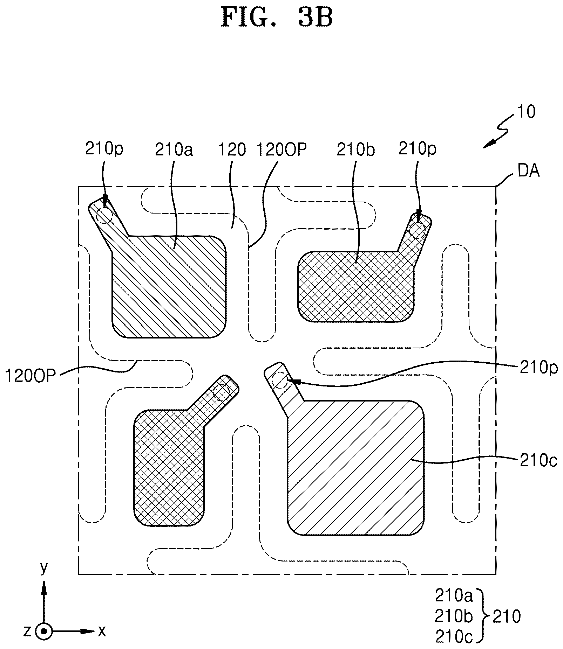

FIG. 3A is a schematic plan view of a portion of the display panel 10 according to an aspect. FIG. 3B is a schematic plan view of a portion of the display panel 10 according to an aspect.

FIG. 3A illustrates first to third pixels P1, P2, and P3, an inorganic insulating layer 120, a pixel-defining layer 130, and a separator SEP in the display area DA of the display panel 10. FIG. 3B illustrates a pixel electrode 210 and the inorganic insulating layer 120, excluding the pixel-defining layer 130 that is illustrated in FIG. 3A.

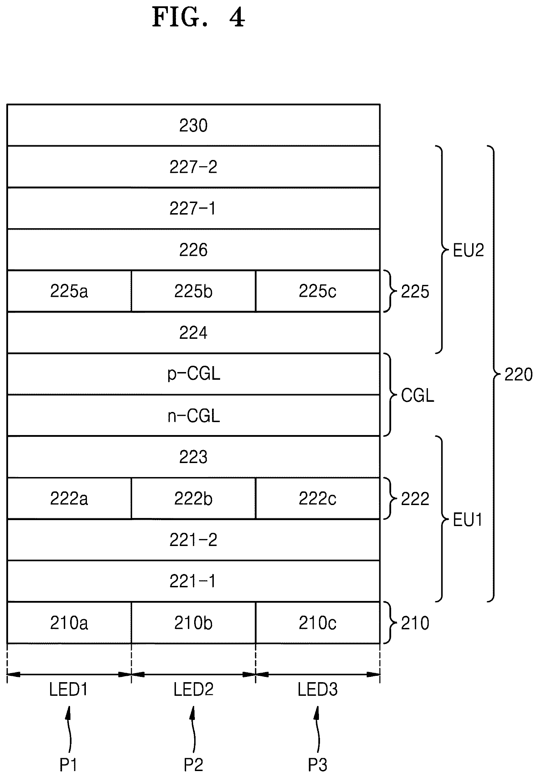

Referring to FIGS. 3A and 3B, the first to third pixels P1, P2, and P3 may be arranged in the display area DA of the display panel 10. In an aspect, each of the first to third pixels P1, P2, and P3 may include a display element, such as a light-emitting diode, and a pixel circuit electrically connected to the display element. For example, a first pixel P1 may include a first light-emitting diode LED1 (see FIG. 4) and a first pixel circuit, a second pixel P2 may include a second light-emitting diode LED2 (see FIG. 4) and a second pixel circuit, and a third pixel P3 may include a third light-emitting diode LED3 (see FIG. 4) and a third pixel circuit.

In an aspect, the first to third pixels P1, P2, and P3 may include the first pixel P1, the second pixel P2, and the third pixel P3 that emit light of different colors. For example, the first pixel P1 may emit red light, the second pixel P2 may emit green light, and the third pixel P3 may emit blue light. Red light may be light in a wavelength range of about 580 nm to about 780 nm, green light may be light in a wavelength range of about 495 nm to about 580 nm, and blue light may be light in a wavelength range of about 400 nm to about 495 nm. In an aspect, each of the first pixel P1, the second pixel P2, and the third pixel P3 may emit white light. Hereinafter, a case where the first to third pixels P1, P2, and P3 emit light of different colors will be mainly described.

The first pixel P1, the second pixel P2, and the third pixel P3 may be arranged in a regular pattern, such as a stripe arrangement, a Pentile^{®} arrangement, or the like. In an aspect, the first pixel P1 and the second pixel P2 may alternately form a first pixel column along the second direction (y direction), and the second pixel P2 and the third pixel P3 may alternately form a second pixel column along the second direction (y direction). The first pixel column and the second pixel column may be arranged alternately along the first direction (x direction).

The inorganic insulating layer 120 may overlap display elements of the first to third pixels P1, P2, and P3. For example, as illustrated in FIG. 3B, the inorganic insulating layer 120 may overlap a first pixel electrode 210a of the first pixel P1, a second pixel electrode 210b of the second pixel P2, and a third pixel electrode 210c of the third pixel P3. For example, the inorganic insulating layer 120 may be disposed below the first pixel electrode 210a of the first pixel P1, the second pixel electrode 210b of the second pixel P2, and the third pixel electrode 210c of the third pixel P3.

The inorganic insulating layer 120 may include a first opening 120OP between adjacent pixels among the first to third pixels P1, P2, and P3. For example, the first opening 120OP of the inorganic insulating layer 120 may be located between the first pixel P1 and the second pixel P2, and between the second pixel P2 and the third pixel P3.

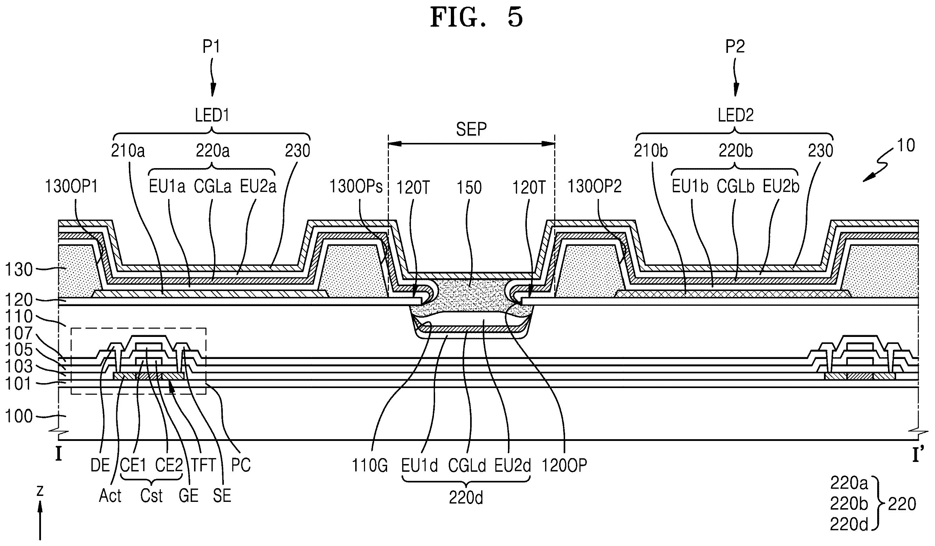

The first pixel electrode 210a of the first pixel P1, the second pixel electrode 210b of the second pixel P2, and the third pixel electrode 210c of the third pixel P3 may include contact portions 210p electrically connected to the first pixel circuit of the first pixel P1, the second pixel circuit of the second pixel P2, and the third pixel circuit of the third pixel P3, respectively. The structure of each of the first pixel circuit of the first pixel P1, the second pixel circuit of the second pixel P2, and the third pixel circuit of the third pixel P3 may correspond to a pixel circuit PC described below with reference to FIG. 5. The contact portion 210p may be disposed in an opening penetrating an organic insulating layer 110 and an inorganic insulating layer 120 described below with reference to FIG. 5, and may be electrically connected to a transistor TFT (see FIG. 5).

The pixel-defining layer 130 may define a plurality of pixel openings 130OP1, 130OP2, and 130OP3. The pixel-defining layer 130 may define emission areas of the first pixel P1, the second pixel P2, and the third pixel P3 through the plurality of pixel openings 130OP1, 130OP2, and 130OP3, respectively. For example, an emission area of the first pixel P1 may be defined by a first pixel opening 130OP1, an emission area of the second pixel P2 may be defined by a second pixel opening 130OP2, and an emission area of the third pixel P3 may be defined by a third pixel opening 130OP3.

Each of the first pixel opening 130OP1, the second pixel opening 130OP2, and the third pixel opening 130OP3 may have an approximately rectangular shape in a plan view, but the disclosure is not limited thereto. In an aspect, each of the first pixel opening 130OP1, the second pixel opening 130OP2, and the third pixel opening 130OP3 may have a polygonal shape, a circular shape, an elliptical shape, or the like. In an aspect, the first pixel opening 130OP1, the second pixel opening 130OP2, and the third pixel opening 130OP3 may have a chamfered shape.

In an aspect, the first pixel opening 130OP1, the second pixel opening 130OP2, and the third pixel opening 130OP3 may have different sizes (or areas). For example, a size (or area) of the third pixel opening 130OP3 may be larger than a size (or area) of the first pixel opening 130OP1 and a size (or area) of the second pixel opening 130OP2, and the size (or area) of the first pixel opening 130OP1 may be larger than or equal to a size (or area) of the second pixel opening 130OP2. In an aspect, the first pixel opening 130OP1, the second pixel opening 130OP2, and the third pixel opening 130OP3 may have a same size (or area).

The pixel-defining layer 130 may define a separator opening 130OPs. The separator opening 130OPs of the pixel-defining layer 130 may overlap (or be connected to) the first opening 120OP of the inorganic insulating layer 120. The separator opening 130OPs of the pixel-defining layer 130 may be located between adjacent pixel openings. For example, the separator opening 130OPs of the pixel-defining layer 130 may be located between the first pixel opening 130OP1 and the second pixel opening 130OP2 and between the second pixel opening 130OP2 and the third pixel opening 130OP3. A plurality of the separator openings 130OPs may surround at least part of each of the first pixel opening 130OP1, the second pixel opening 130OP2, and the third pixel opening 130OP3, in a plan view.

The pixel-defining layer 130 may include an organic insulating material such as benzocyclobutene (BCB), polyimide, or hexamethyldisiloxane (HMDSO). The pixel-defining layer 130 may be black. In an aspect, the pixel-defining layer 130 may include a light-blocking material and may be provided in black. The light-blocking material may include carbon black, carbon nanotubes, resin or paste including black dye, metal particles such as nickel (Ni), aluminium (Al), molybdenum (Mo), and alloys thereof, metal oxide particles (e.g., chromium oxide), or metal nitride particles (e.g., chromium nitride). When the pixel-defining layer 130 includes a light-blocking material, external light reflection caused by metal structures disposed below the pixel-defining layer 130 may be reduced.

The display panel 10 may include separators SEP. In an aspect, each of the separators SEP may include a portion of the inorganic insulating layer 120 (e.g., a tip 120T (see FIG. 5) of the inorganic insulating layer 120 and a groove 110G (see FIG. 5) of the organic insulating layer 110 (see FIG. 5) that are exposed by the separator opening 130OPs of the pixel-defining layer 130. The separators SEP may surround at least part of each of the first pixel opening 130OP1, the second pixel opening 130OP2, and the third pixel opening 130OP3, in a plan view. The separators SEP may surround entirely each of the first pixel opening 130OP1, the second pixel opening 130OP2, and the third pixel opening 130OP3, in a plan view. In an aspect, the separators SEP are illustrated as a plurality spaced apart from each other, but are not limited thereto. For example, the separator SEP may have a shape in which at least one side is open, surrounding each of the first pixel opening 130OP1, the second pixel opening 130OP2, and the third pixel opening 130OP3, in a plan view.

Separators SEP separate intermediate layers 220 (see FIG. 4) of the first pixel P1, the second pixel P2, and the third pixel P3, thereby reducing leakage current through the intermediate layers 220 between adjacent pixels.

FIG. 4 is a schematic cross-sectional view of the display element according to an aspect.

Referring to FIG. 4, the display element according to one aspect of the present disclosure may be a light-emitting diode. Each of the first light-emitting diode LED1 included in the first pixel P1, the second light-emitting diode LED2 included in the second pixel P2, and the third light-emitting diode LED3 included in the third pixel P3 may include a pixel electrode (or anode) 210, an opposite electrode (or cathode) 230, and an intermediate layer 220 between the pixel electrode 210 and the opposite electrode 230.

The pixel electrode 210 may be independently provided in each of the first light-emitting diode LED1, the second light-emitting diode LED2, and the third light-emitting diode LED3. For example, the first light-emitting diode LED1 may include the first pixel electrode 210a, the second light-emitting diode LED2 may include the second pixel electrode 210b, and the third light-emitting diode LED3 may include the third pixel electrode 210c.

The pixel electrode 210 may include a transparent conductive oxide such as indium tin oxide (ITO), indium zinc oxide (IZO), zinc oxide (ZnOₓ), indium oxide (In₂O₃), indium gallium oxide (IGO), indium gallium zinc oxide (IGZO), gallium zinc oxide (GZO), or aluminium zinc oxide (AZO). The pixel electrode 210 may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a compound thereof. For example, the pixel electrode 210 may have a three-layer structure of ITO/Ag/ITO.

The opposite electrode 230 may be disposed on the intermediate layer 220. The opposite electrode 230 may include a metal having a low work function, alloy, conductive compound, or combination thereof. For example, the opposite electrode 230 may include a transparent layer (or a semitransparent layer) including silver (Ag), magnesium (Mg), aluminium (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the opposite electrode 230 may further include a layer including ITO, IZO, ZnOₓ, or In₂O₃ on the transparent layer (or the semitransparent layer) including the above-mentioned material.

The intermediate layer 220 may include a polymer or low-molecular organic material that emits light of a predetermined color. The intermediate layer 220 may include, in addition to various organic substances, metal-containing compounds such as organometallic compounds, and inorganic substances such as quantum dots. In an aspect, the intermediate layer 220 may include two or more emission units sequentially stacked between the pixel electrode 210 and the opposite electrode 230 and a charge generation layer CGL disposed between the two emission units. The light-emitting diode including the intermediate layer 220 including multiple emission units and the charge generation layer CGL may be referred to as a tandem light-emitting diode. Each of the first light-emitting diode LED1, the second light-emitting diode LED2, and the third light-emitting diode LED3 has a structure in which multiple emission units are stacked (e.g., a tandem structure), thereby improving color purity and emission efficiency.

The intermediate layer 220 of each of the first light-emitting diode LED1, the second light-emitting diode LED2, and the third light-emitting diode LED3 may include a first emission unit EU1 and a second emission unit EU2 that are sequentially stacked, and the charge generation layer CGL between the first emission unit EU1 and the second emission unit EU2. The intermediate layers 220 of the first light-emitting diode LED1, the second light-emitting diode LED2, and the third light-emitting diode LED3 may be referred to as a first intermediate layer 220a (see FIG. 5), a second intermediate layer 220b (see FIG. 5), and a third intermediate layer, respectively.

The intermediate layer 220 of each of the first light-emitting diode LED1, the second light-emitting diode LED2, and the third light-emitting diode LED3 may include a plurality of emission layers. For example, the first emission unit EU1 of each of the first light-emitting diode LED1, the second light-emitting diode LED2, and the third light-emitting diode LED3 may include a lower emission layer 222, and the second emission unit EU2 of each of the first light-emitting diode LED1, the second light-emitting diode LED2, and the third light-emitting diode LED3 may include an upper emission layer 225.

Each of the lower emission layer 222 and the upper emission layer 225 may be independently provided by being patterned on each of the first light-emitting diode LED1, the second light-emitting diode LED2, and the third light-emitting diode LED3. For example, the first emission unit EU1 of the first light-emitting diode LED1 may include a first lower emission layer 222a, and the second emission unit EU2 of the first light-emitting diode LED1 may include a first upper emission layer 225a overlapping the first lower emission layer 222a. The first emission unit EU1 of the second light-emitting diode LED2 may include a second lower emission layer 222b, and the second emission unit EU2 of the second light-emitting diode LED2 may include a second upper emission layer 225b overlapping the second lower emission layer 222b. The first emission unit EU1 of the third light-emitting diode LED3 may include a third lower emission layer 222c, and the second emission unit EU2 of the third light-emitting diode LED3 may include a third upper emission layer 225c overlapping the third lower emission layer 222c.

In an aspect, the first lower emission layer 222a, the second lower emission layer 222b, and the third lower emission layer 222c may emit light of different colors. In an aspect, the first upper emission layer 225a, the second upper emission layer 225b, and the third upper emission layer 225c may emit light of different colors. For example, the first lower emission layer 222a and the first upper emission layer 225a may emit red light, the second lower emission layer 222b and the second upper emission layer 225b may emit green light, and the third lower emission layer 222c and the third upper emission layer 225c may emit blue light.

The first to third lower emission layers 222a, 222b, and 222c and the first to third upper emission layers 225a, 225b, and 225c may each include an organic material including a fluorescent or phosphorescent material that emits red, green, or blue light. The first to third lower emission layers 222a, 222b, and 222c and the first to third upper emission layers 225a, 225b, and 225c may be organic emission layers including low-molecular organic substances or high-molecular organic substances.

In an aspect, the first to third lower emission layers 222a, 222b, and 222c and the first to third upper emission layers 225a, 225b, and 225c may include a host material and a dopant material. A dopant material is a material that emits light of a specific color and may include a luminescent material. The luminescent material may include at least one of a phosphorescent dopant, a fluorescent dopant, and a quantum dot. The host material is a main material of the emission layer and is a material that helps the dopant material to emit light.

The charge generation layer CGL may be disposed between the lower emission layer 222 and the upper emission layer 225. The charge generation layer CGL may include a negative charge generation layer n-CGL and a positive charge generation layer p-CGL. The negative charge generation layer n-CGL may be disposed on a second common layer 223, and the positive charge generation layer p-CGL may be disposed on the negative charge generation layer n-CGL.

In an aspect, each of the negative charge generation layer n-CGL and the positive charge generation layer p-CGL may be integrally formed across the first to third light-emitting diodes LED1, LED2, and LED3. In an aspect, the negative charge generation layer n-CGL may be formed integrally across the first to third light-emitting diodes LED1, LED2, and LED3, and the positive charge generation layer p-CGL may be patterned and independently provided on each of the first to third light-emitting diodes LED1, LED2, and LED3.

The negative charge generation layer n-CGL may be an n-type charge generation layer. The negative charge generation layer n-CGL may supply electrons. The negative charge generation layer n-CGL may include an n-type host material and an n-type dopant. The n-type dopant material may be a metal of group 1 or group 2 of the periodic table, an organic material capable of donating electrons, or a mixture thereof. For example, the n-type dopant material may be an alkali metal or an alkaline earth metal. The negative charge generation layer n-CGL may be formed of an organic layer doped with an alkali metal such as lithium (Li), sodium (Na), potassium (K), or cesium (Cs), or an alkaline earth metal such as magnesium (Mg), strontium (Sr), barium (Ba), or radium (Ra), but the present disclosure is not limited thereto. The n-type host material may include an organic material capable of transferring electrons. For example, the n-type host material may include at least one of Alq₃ (tris(8-hydroxyquinolinato)aluminium), Liq (8-hydroxyquinolinolato-lithium), PBD (2-(4-biphenylyl)-5-(4-tert-butylphenyl)-1,3,4-oxadiazole), TAZ (3-(4-biphenyl)-4-phenyl-5-tert-butylphenyl-1,2,4-triazole), spiro-PBD, and BAlq (bis(2-methyl-8-quinolinolate)-4-(phenylphenolato)aluminium), SAIq, TPBi (2,2',2"-(1,3,5-benzinetriyl)-tris(1-phenyl-1-H-benzimidazole)), oxadiazole, triazole, phenanthroline, benzoxazole, or benzthiazole, and the present disclosure is not limited thereto.

The positive charge generation layer p-CGL may be a p-type charge generation layer. The positive charge generation layer p-CGL may supply holes. The positive charge generation layer p-CGL may include a p-type host material and a p-type dopant material. The p-type dopant material may include a metal oxide, an organic material such as tetrafluoro-tetracyanoquinodimethane (F4-TCNQ), HAT-CN (Hexaazatriphenylene-hexacarbonitrile), and hexaazatriphenylene, or a metal material such as V₂O₅, MoOₓ, and WO₃, but present disclosure is not limited thereto. The p-type host material may include a material including at least one of an organic material capable of transporting holes, for example, NPD (N,N'-bis(naphthalene-1-yl)-N,N'-bis(phenyl)dimethylbenzidine), TPD (N,N'-bis-(3-methylphenyl)-N,N'-diphenylbenzidine) and MTDATA (4,4',4"-Tris(N-(3-methylphenyl)-N-phenylamino)-triphenylamine), but the present disclosure is not limited thereto.

The first emission unit EU1 may further include a first-1 common layer 221-1, a first-2 common layer 221-2, and a second common layer 223. The first-1 common layer 221-1 may be disposed on the pixel electrode 210, and the first-2 common layer 221-2 may be disposed on the first-1 common layer 221-1. The second common layer 223 may be disposed on the lower emission layer 222.

Each of the first-1 common layer 221-1 and the first-2 common layer 221-2 may be disposed between the pixel electrode 210 and the lower emission layer 222. For example, each of the first-1 common layer 221-1 and the first-2 common layer 221-2 may be disposed between the first pixel electrode 210a and the first lower emission layer 222a, between the second pixel electrode 210b and the second lower emission layer 222b, and between the third pixel electrode 210c and the third lower emission layer 222c.

A hole transport region may include the first-1 common layer 221-1 and the first-2 common layer. The hole transport region may have a single-layer structure or a multi-layer structure. For example, the first-1 common layer 221-1 of the hole transport region may be a hole injection layer (HIL), and the first-2 common layer 221-2 may be a hole transport layer (HTL). Additionally, the hole transport region may further include an electron blocking layer (EBL), although this is not shown. Each of the first-1 common layer 221-1 and the first-2 common layer 221-2 may be integrally formed across the first to third light-emitting diodes LED1, LED2, and LED3.

The second common layer 223 may be disposed between the lower emission layer 222 and the charge generation layer CGL. For example, the second common layer 223 may be disposed between the first lower emission layer 222a and the charge generation layer CGL, between the second lower emission layer 222b and the charge generation layer CGL, and between the third lower emission layer 222c and the charge generation layer CGL. The second common layer 223 may be formed integrally across the first to third light-emitting diodes LED1, LED2, and LED3. The second common layer 223 may be an electron transport layer (ETL). The second common layer 223 may be disposed below the negative charge generation layer n-CGL. The electron transport layer and the negative charge generation layer n-CGL may include a same material. The negative charge generation layer n-CGL may be a layer doped with an n-type dopant in the same material as the electron transport layer.

The second emission unit EU2 may include a third common layer 224, a fourth-1 common layer 227-1, and a fourth-2 common layer 227-2. The second emission unit EU2 may further include a light-emitting diode buffer layer 226. The third common layer 224 may be disposed on the charge generation layer CGL. The light-emitting diode buffer layer 226 may be disposed on the upper emission layer 225. The fourth-1 common layer 227-1 may be disposed on the light-emitting diode buffer layer 226, and the fourth-2 common layer 227-2 may be disposed on the fourth-1 common layer 227-1.

The third common layer 224 may be disposed between the charge generation layer CGL and the upper emission layer 225. The third common layer 224 may be disposed between the positive charge generation layer p-CGL and the upper emission layer 225. For example, the third common layer 224 may be disposed between the charge generation layer CGL and the first upper emission layer 225a, between the charge generation layer CGL and the second upper emission layer 225b, and between the charge generation layer CGL and the third upper emission layer 225c. The third common layer 224 may be formed integrally across the first to third light-emitting diodes LED1, LED2, and LED3.

The third common layer 224 may be a hole transport layer (HTL) that may transfer holes generated in the charge generation layer CGL to the second emission unit EU2.

Each of the light-emitting diode buffer layer 226, the fourth-1 common layer 227-1, and the fourth-2 common layer 227-2 may be disposed between the upper emission layer 225 and the opposite electrode 230.

The light-emitting diode buffer layer 226 may be disposed between the upper emission layer 225 and the fourth-1 common layer 227-1. The light-emitting diode buffer layer 226 may include an inorganic material such as silicon oxide, silicon nitride, and/or silicon oxynitride.

An electron transport region may include the fourth-1 common layer 227-1 and the fourth-2 common layer 227-2. The electron transport region may have a single-layer structure or a multi-layer structure. For example, the fourth-1 common layer 227-1 of the electron transport region may be an electron transport layer (ETL), and the fourth-2 common layer 227-2 may be an electron injection layer (EIL). Each of the fourth-1 common layer 227-1 and the fourth-2 common layer 227-2 may be integrally formed across the first to third light-emitting diodes LED1, LED2, and LED3.

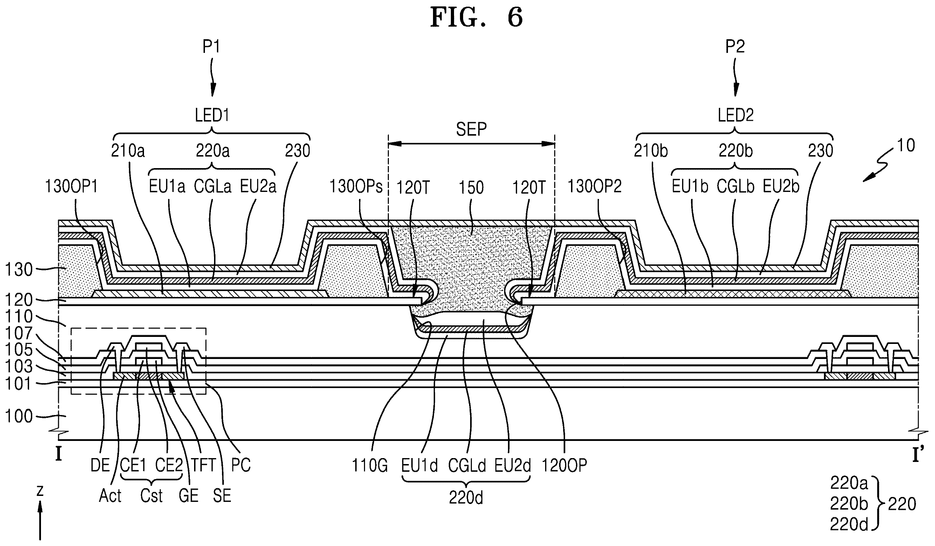

FIG. 5 is a schematic cross-sectional view of the display panel 10 according to an aspect, taken along line I-I' of FIG. 3A. FIG. 6 is a schematic cross-sectional view of the display panel 10 according to an aspect, taken along line I-I' of FIG. 3A.

Referring to FIGS. 5 and 6, the display panel 10 may include a substrate 100, the transistor TFT on the substrate 100, the organic insulating layer 110 disposed on the transistor TFT, and the display element (e.g., the first light-emitting diode LED1, the second light-emitting diode LED2, and the third light-emitting diode LED3 (see FIG. 4) on the organic insulating layer 110. The display element may be electrically connected to a transistor TFT.

The substrate 100 may include glass, metal, or a polymer resin. The polymer resin may include polyethersulfone, polyacrylate, polyetherimide, polyethylene naphthalate, polyethylene terephthalate, polyphenylene sulfide, polyarylate, polyimide, polycarbonate, cellulose acetate propionate or mixtures thereof. In an aspect, the substrate 100 may have a multi-layer structure including at least two base layers each including the polymer resin such as described above and an inorganic layer interposed between the base layers.

A buffer layer 101 may be disposed on the substrate 100. The buffer layer 101 may include an inorganic material such as silicon oxide, silicon nitride, and/or silicon oxynitride. The buffer layer 101 may increase the planarity of an upper surface of the substrate 100 or prevent or minimize the penetration of impurities into an active layer Act of the transistor TFT from the substrate 100 side.

The pixel circuit PC may be disposed on the buffer layer 101. The pixel circuit PC may include a transistor TFT and a capacitor Cst. The transistor TFT may include the active layer Act, a gate electrode GE, a source electrode SE, and a drain electrode DE.

The active layer Act may be disposed on the buffer layer 101. In an aspect, the active layer Act may include a silicon-based semiconductor material, such as amorphous silicon or polycrystalline silicon. In an aspect, the active layer Act may include an oxide semiconductor material of at least one material selected from indium (In), gallium (Ga), tin (Sn), zirconium (Zr), vanadium (V), hafnium (Hf), cadmium (Cd), germanium (Ge), chromium (Cr), titanium (Ti), aluminium (Al), cesium (Cs), cerium (Ce), and zinc (Zn).

A gate insulating layer 103 may be disposed on the active layer Act, and the gate electrode GE may be disposed on the gate insulating layer 103 to overlap the active layer Act in a plan view. The gate electrode GE may include a conductive material such as molybdenum (Mo), aluminium (Al), copper (Cu), titanium (Ti), indium tin oxide (ITO), or indium zinc oxide (IZO), and may be a multi-layer structure or single-layer structure including the above materials.

A first interlayer insulating layer 105 may be disposed on the gate electrode GE, and a second capacitor electrode CE2 may be disposed on the first interlayer insulating layer 105. At least a portion of the gate electrode GE may overlap the second capacitor electrode CE2 in a plan view and function as a first capacitor electrode CE1 of the capacitor Cst. In other words, the gate electrode GE and the first capacitor electrode CE1 may be integrally provided. The second capacitor electrode CE2 may include a conductive material such as molybdenum (Mo), aluminium (Al), copper (Cu), titanium (Ti), indium tin oxide (ITO), or indium zinc oxide (IZO), and may be a multi-layer structure or single-layer structure including the above materials.

A second interlayer insulating layer 107 may be disposed on the second capacitor electrode CE2, and the source electrode SE and the drain electrode DE may be disposed on the second interlayer insulating layer 107. The source electrode SE and the drain electrode DE may each include a conductive material such as molybdenum (Mo), aluminium (Al), copper (Cu), titanium (Ti), indium tin oxide (ITO), or indium zinc oxide (IZO), and may be a multi-layer structure or single-layer structure including the above materials. For example, the source electrode SE and drain electrode DE may each have the multi-layer structure of Ti/Al/Ti.

Each of the gate insulating layer 103, the first interlayer insulating layer 105, and the second interlayer insulating layer 107 may include an inorganic material such as silicon oxide, silicon nitride, and/or silicon oxynitride, and may be a multi-layer structure or single-layer structure including the above materials.

The organic insulating layer 110 may be disposed on the pixel circuit PC. The organic insulating layer 110 includes the groove 110G. The groove 110G may be a shape in which a portion of the organic insulating layer 110 is removed in a direction toward the upper surface of the substrate 100. For example, the organic insulating layer 110 may have an undercut shape having a side surface that is more recessed than a side surface of the tip 120T of the inorganic insulating layer 120 described later.

The organic insulating layer 110 may include an organic insulating material. For example, the organic insulating layer 110 may include benzocyclobutene (BCB), polyimide, hexamethyldisiloxane (HMDSO), polymethylmethacrylate (PMMA), polystyrene, a polymer derivative having a phenol-based group, acryl-based polymer, imide-based polymer, arylether-based polymer, amide-based polymer, fluorine-based polymer, p-xylene-based polymer, vinyl alcohol-based polymer, or a compound thereof.

The inorganic insulating layer 120 is disposed on the organic insulating layer 110. The inorganic insulating layer 120 may include the first opening 120OP that overlaps (or is connected to) the groove 110G of the organic insulating layer 110. The first opening 120OP of the inorganic insulating layer 120 may be located between the first light-emitting diode LED1 and the second light-emitting diode LED2. For example, the first opening 120OP of the inorganic insulating layer 120 may be located between the first pixel electrode 210a and the second pixel electrode 210b.

The inorganic insulating layer 120 includes the tip 120T that overlaps the groove 110G of the organic insulating layer 110 and extends toward a center of the groove 110G. The tip 120T of the inorganic insulating layer 120 may be exposed through the separator opening 130OPs of the pixel-defining layer 130. The tip 120T of the inorganic insulating layer 120 may protrude in a direction toward the center of the groove 110G more than a side surface of the pixel-defining layer 130 defining the separator opening 130OPs. For example, the tip 120T of the inorganic insulating layer 120 may be defined as a portion that protrudes further than a side surface of the organic insulating layer 110 that defines the groove 110G of the organic insulating layer 110. That is, the side of the tip 120T of the inorganic insulating layer 120 may protrude toward the center of the groove 110G more than the side of the organic insulating layer 110 defining the groove 110G. In an aspect, the tip 120T of the inorganic insulating layer 120 may overlap a portion of a dummy intermediate layer 220d.

For example, the inorganic insulating layer 120 may include an inorganic insulating material, such as silicon nitride (SiNₓ).

The first light-emitting diode LED1 and the second light-emitting diode LED2 may be spaced apart from each other on the inorganic insulating layer 120. The first light-emitting diode LED1 may include the first pixel electrode 210a, the first intermediate layer 220a, and the opposite electrode 230. The second light-emitting diode LED2 may include the second pixel electrode 210b, the second intermediate layer 220b, and the opposite electrode 230.

The first pixel electrode 210a and the second pixel electrode 210b may be spaced apart from each other on the inorganic insulating layer 120. The first pixel electrode 210a and the second pixel electrode 210b may be spaced apart from each other, and the separator SEP may be located between the first pixel electrode 210a and the second pixel electrode 210b. For example, the first pixel electrode 210a and the second pixel electrode 210b may be spaced apart from each other, and the tip 120T of the inorganic insulating layer 120 and the groove 110G of the organic insulating layer 110 may each be located between the first pixel electrode 210a and the second pixel electrode 210b.

The pixel-defining layer 130 may be disposed on the first pixel electrode 210a and the second pixel electrode 210b. The pixel-defining layer 130 may cover an edge of the first pixel electrode 210a and an edge of the second pixel electrode 210b. The pixel-defining layer 130 may include the first pixel opening 130OP1 exposing a portion of the first pixel electrode 210a and the second pixel opening 130OP2 exposing a portion of the second pixel electrode 210b. The pixel-defining layer 130 may include the separator opening 130OPs located between the first light-emitting diode LED1 and the second light-emitting diode LED2 and overlapping (or connected to) the first opening 120OP of the inorganic insulating layer 120.

The separator SEP may be defined by the groove 110G of the organic insulating layer 110 and the tip 120T of the inorganic insulating layer 120 in an area exposed by the separator opening 130OPs. The separator SEP may be located between the first light-emitting diode LED1 and the second light-emitting diode LED2 to separate the first intermediate layer 220a of the first light-emitting diode LED1 and the second intermediate layer 220b of the second light-emitting diode LED2.

The intermediate layer 220 may include the first intermediate layer 220a, the second intermediate layer 220b, and the dummy intermediate layer 220d. The first intermediate layer 220a may be disposed on the first pixel electrode 210a, and the second intermediate layer 220b may be disposed on the second pixel electrode 210b. The dummy intermediate layer 220d may be disposed in the groove 110G of the organic insulating layer 110 (or on the groove 110G). In FIG. 5, an upper surface of the dummy intermediate layer 220d is depicted as being disposed below the inorganic insulating layer 120, but this is not limited to the case, and the upper surface of the dummy intermediate layer 220d may be disposed above the upper surface of the inorganic insulating layer 120.

The intermediate layer 220 may be separated into the first intermediate layer 220a, the second intermediate layer 220b, and the dummy intermediate layer 220d by the separator SEP. That is, the intermediate layer 220 may be separated into the first intermediate layer 220a, the second intermediate layer 220b, and the dummy intermediate layer 220d by the tip 120T of the inorganic insulating layer 120 and the groove 110G of the organic insulating layer 110. For example, the dummy intermediate layer 220d may be separated from the first intermediate layer 220a and the second intermediate layer 220b in the separator opening 130OPs. Because the first intermediate layer 220a and the second intermediate layer 220b are separated from each other with the dummy intermediate layer 220d located between the first intermediate layer 220a and the second intermediate layer 220b, leakage current flowing between the adjacent first light-emitting diode LED1 and second light-emitting diode LED2 through the intermediate layer 220 may be reduced or prevented. Accordingly, the display panel 10 may display a high-quality image without any staining or color mixing.

Each of the first intermediate layer 220a and the second intermediate layer 220b may include the multiple emission units and the charge generation layer disposed between the multiple emission units as described with reference to FIG. 4. For example, the first intermediate layer 220a may include a first-1 emission unit EU1a, a second-1 emission unit EU2a, and a first charge generation layer CGLa disposed between the first-1 emission unit EU1a and the second-1 emission unit EU2a. For example, the second intermediate layer 220b may include a first-2 emission unit EU1b, a second-2 emission unit EU2b, and a second charge generation layer CGLb disposed between the first-2 emission unit EU1b and the second-2 emission unit EU2b. That is, each of the first light-emitting diode LED1 and the second light-emitting diode LED2 may be a tandem light-emitting diode.

The first-1 emission unit EU1a of the first intermediate layer 220a may include the first lower emission layer 222a (see FIG. 4). The first lower emission layer 222a (see FIG. 4) may be disposed in the first pixel opening 130OP1. The second-1 emission unit EU2a of the first intermediate layer 220a (see FIG. 4) may include the first upper emission layer 225a (see FIG. 4). The first upper emission layer 225a may be disposed in the first pixel opening 130OP1. The first lower emission layer 222a (see FIG. 4) and the first upper emission layer 225a (see FIG. 4) may overlap each other, in the first pixel opening 130OP1.

The first-2 emission unit EU1b of the second intermediate layer 220b may include the second lower emission layer 222b (see FIG. 4). The second lower emission layer 222b may be disposed in the second pixel opening 130OP2. The second-2 emission unit EU2b of the second intermediate layer 220b may include the second upper emission layer 225b (see FIG. 4). The second upper emission layer 225b may be disposed in the second pixel opening 130OP2. The second lower emission layer 222b (see FIG. 4) and the second upper emission layer 225b (see FIG. 4) may overlap each other, in the second pixel opening 130OP2.

The dummy intermediate layer 220d may include a first dummy layer EU1d, a second dummy layer EU2d, and a dummy charge generation layer CGLd disposed between the first dummy layer EU1d and the second dummy layer EU2d. Each of the first dummy layer EU1d and the second dummy layer EU2d may not include an emission layer.

Each of a plurality of common layers included in the intermediate layer 220 may be formed across the first light-emitting diode LED1 and the second light-emitting diode LED2, and may be separated and spaced apart by the separator SEP. For example, the first-1 emission unit EU1a of the first intermediate layer 220a, the first-2 emission unit EU1b of the second intermediate layer 220b, and the first dummy layer EU1d of the dummy intermediate layer 220d may each include the first-1 common layer 221-1, the first-2 common layer 221-2, and the second common layer 223 described with reference to FIG. 4, and the first-1 emission unit EU1a of the first intermediate layer 220a, the first-2 emission unit EU1b of the second intermediate layer 220b, and the first dummy layer EU1d of the dummy intermediate layer 220d may be separated and spaced apart by the separator SEP. For example, the second-1 emission unit EU2a of the first intermediate layer 220a, the second-2 emission unit EU2b of the second intermediate layer 220b, and the second dummy layer EU2d of the dummy intermediate layer 220d may each include the third common layer 224, the fourth-1 common layer 227-1, and the fourth-2 common layer 227-2 described with reference to FIG. 4, and the second-1 emission unit EU2a of the first intermediate layer 220a, the second-2 emission unit EU2b of the second intermediate layer 220b, and the second dummy layer EU2d of the dummy intermediate layer 220d may be separated and spaced apart by the separator SEP.

The charge generation layer CGL (see FIG. 4) included in the intermediate layer 220 may be formed across the first light-emitting diode LED1 and the second light-emitting diode LED2, and may be separated and spaced apart by the separator SEP. For example, the first charge generation layer CGLa of the first intermediate layer 220a, the second charge generation layer CGLb of the second intermediate layer 220b, and the dummy charge generation layer CGLd of the dummy intermediate layer 220d may be separated and spaced apart by the separator SEP.

An intermediate insulating layer 150 may be disposed on the dummy intermediate layer 220d. The intermediate insulating layer 150 may be disposed in the separator opening 130OPs. In an aspect, the intermediate insulating layer 150 may be located between the first light-emitting diode LED1 and the second light-emitting diode LED2. For example, the intermediate insulating layer 150 may be located between the first pixel electrode 210a and the second pixel electrode 210b. For example, the intermediate insulating layer 150 may not overlap the first pixel electrode 210a and the second pixel electrode 210b. For example, the intermediate insulating layer 150 may be located between the first intermediate layer 220a and the second intermediate layer 220b. In an aspect, at least a portion of the intermediate insulating layer 150 may be disposed in the groove 110G of the organic insulating layer 110. In an aspect, at least a portion of the intermediate insulating layer 150 may overlap the tip 120T of the inorganic insulating layer 120. In an aspect, at least a portion of the intermediate insulating layer 150 may be disposed between the tip 120T of the inorganic insulating layer 120 and the dummy intermediate layer 220d. For example, the intermediate insulating layer 150 may be disposed between a portion of the first intermediate layer 220a disposed on the tip 120T of the inorganic insulating layer 120 (or a portion of the first intermediate layer 220a adjacent to the tip 120T of the inorganic insulating layer 120) and the dummy intermediate layer 220d, and between a portion of the second intermediate layer 220b disposed on the tip 120T of the inorganic insulating layer 120 (or a portion of the second intermediate layer 220b adjacent to the tip 120T of the inorganic insulating layer 120) and the dummy intermediate layer 220d.

In an aspect, the intermediate insulating layer 150 may be in contact with each of the first intermediate layer 220a and the second intermediate layer 220b.

In an aspect, a distance between an upper surface of the intermediate insulating layer 150 and the upper surface of the substrate 100 may be greater than a distance between an upper surface of the inorganic insulating layer 120 and the upper surface of the substrate 100.

In an aspect, as illustrated in FIG. 5, the distance between the upper surface of the intermediate insulating layer 150 and the upper surface of the substrate 100 may be smaller than a distance between an upper surface of the pixel-defining layer 130 and the upper surface of the substrate 100. However, the present disclosure is not limited thereto, and as illustrated in FIG. 6, the distance between the upper surface of the intermediate insulating layer 150 and the upper surface of the substrate 100 may be greater than the distance between the upper surface of the pixel-defining layer 130 and the upper surface of the substrate 100. In an aspect, the distance between the upper surface of the intermediate insulating layer 150 and the upper surface of the substrate 100 may be substantially equal to the distance between the upper surface of the pixel-defining layer 130 and the upper surface of the substrate 100.

The intermediate insulating layer 150 may include an organic insulating material. For example, the intermediate insulating layer 150 may further include a black material (e.g., carbon black, carbon nanotubes, black pigment, or black dye). That is, the intermediate insulating layer 150 may be black. Because the intermediate insulating layer 150 may be black, the black visibility characteristics of the display panel 10 may be improved.

In an aspect, the opposite electrode 230 may be disposed on the first intermediate layer 220a, the second intermediate layer 220b, and the intermediate insulating layer 150. In an aspect, the opposite electrode 230 may be in contact with the intermediate insulating layer 150. In an aspect, the opposite electrode 230 may be provided integrally across the first light-emitting diode LED1 and the second light-emitting diode LED2.

Each of the first charge generation layer CGLa and the second charge generation layer CGLb may be spaced apart from the opposite electrode 230 by the intermediate insulating layer 150 in an area overlapping the groove 110G of the organic insulating layer 110 or in the separator opening 130OPs. The portion of the first intermediate layer 220a disposed on the tip 120T of the inorganic insulating layer 120 and the portion of the second intermediate layer 220b disposed on the tip 120T of the inorganic insulating layer 120 may be covered by the intermediate insulating layer 150. For example, even if a portion of the first charge generation layer CGLa disposed on the tip 120T of the inorganic insulating layer 120 and a portion of the second charge generation layer CGLb disposed on the tip 120T of the inorganic insulating layer 120 are exposed by the separator opening 130OPs, the first charge generation layer CGLa and the second charge generation layer CGLb are covered by the intermediate insulating layer 150 so as not to be in contact with the opposite electrode 230, so that each of the first charge generation layer CGLa and the second charge generation layer CGLb may be electrically insulated from the opposite electrode 230. By the intermediate insulating layer 150, not only are the first intermediate layer 220a and the second intermediate layer 220b separated from each other, but also each of the first charge generation layer CGLa and the second charge generation layer CGLb is stably insulated from the opposite electrode 230, so that current leakage between the first light-emitting diode LED1 and the second light-emitting diode LED2, current leakage between the first charge generation layer CGLa and the opposite electrode 230, and current leakage between the second charge generation layer CGLb and the opposite electrode 230 may be reduced or prevented.

In the following aspects, redundant descriptions with reference to Fig. 5 are omitted, and only the differences are described.

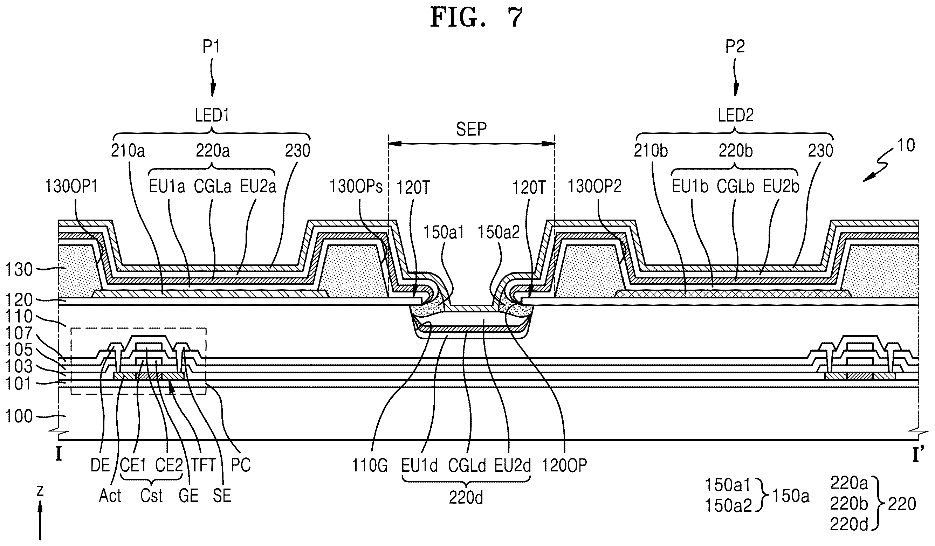

FIG. 7 is a schematic cross-sectional view of the display panel 10 according to an aspect, taken along line I-I' of FIG. 3A.

Referring to FIG. 7, the intermediate insulating layer 150a may include a first intermediate insulating layer 150a1 and a second intermediate insulating layer 150a2 that are spaced apart from each other.

In an aspect, at least a portion of the first intermediate insulating layer 150a1 and at least a portion of the second intermediate insulating layer 150a2 may each be disposed between the tip 120T of the inorganic insulating layer 120 and the dummy intermediate layer 220d. In a cross-section, at least a portion of the first intermediate insulating layer 150a1 may be located between the first intermediate layer 220a and the dummy intermediate layer 220d. In a cross-section, at least a portion of the second intermediate insulating layer 150a2 may be located between the second intermediate layer 220b and the dummy intermediate layer 220d. For example, the first intermediate insulating layer 150a1 may be disposed between the portion of the first intermediate layer 220a disposed on the tip 120T of the inorganic insulating layer 120 and the dummy intermediate layer 220d. For example, the second intermediate insulating layer 150a2 may be disposed between the portion of the second intermediate layer 220b disposed on the tip 120T of the inorganic insulating layer 120 and the dummy intermediate layer 220d.

In an aspect, the first intermediate insulating layer 150a1 may be in contact with the first intermediate layer 220a, and the second intermediate insulating layer 150a2 may be in contact with the second intermediate layer 220b. In an aspect, the first intermediate insulating layer 150a1 may be in contact with the first charge generation layer CGLa, and the second intermediate insulating layer 150a2 may be in contact with the second charge generation layer CGLb.

In an aspect, a distance between a top of the first intermediate insulating layer 150a1 and the upper surface of the substrate 100 may be greater than the distance between the upper surface of the inorganic insulating layer 120 and the upper surface of the substrate 100. A distance between a top of the second intermediate insulating layer 150a2 and the upper surface of the substrate 100 may be greater than the distance between the upper surface of the inorganic insulating layer 120 and the upper surface of the substrate 100.

In an aspect, the opposite electrode 230 may be disposed on the first intermediate layer 220a, the second intermediate layer 220b, the intermediate insulating layer 150a, and the dummy intermediate layer 220d. In an aspect, the opposite electrode 230 may be in contact with each of the first intermediate insulating layer 150a1, the second intermediate insulating layer 150a2, and the dummy intermediate layer 220d.

The first charge generation layer CGLa may be spaced apart from the opposite electrode 230 by the first intermediate insulating layer 150a1 in an area overlapping the groove 110G of the organic insulating layer 110 or in the separator opening 130OPs. Because an end of the first intermediate layer 220a disposed on the tip 120T of the inorganic insulating layer 120 is in contact with the first intermediate insulating layer 150a1, an end of the first charge generation layer CGLa is not exposed, so the first charge generation layer CGLa may be electrically insulated from the opposite electrode 230. Because an end of the second intermediate layer 220b disposed on the tip 120T of the inorganic insulating layer 120 is in contact with the second intermediate insulating layer 150a2, an end of the second charge generation layer CGLb is not exposed, so the second charge generation layer CGLb may be electrically insulated from the opposite electrode 230. Accordingly, because each of the first charge generation layer CGLa and the second charge generation layer CGLb is stably insulated from the opposite electrode 230, current leakage between the first charge generation layer CGLa and the opposite electrode 230 and current leakage between the second charge generation layer CGLb and the opposite electrode 230 may be reduced or prevented.

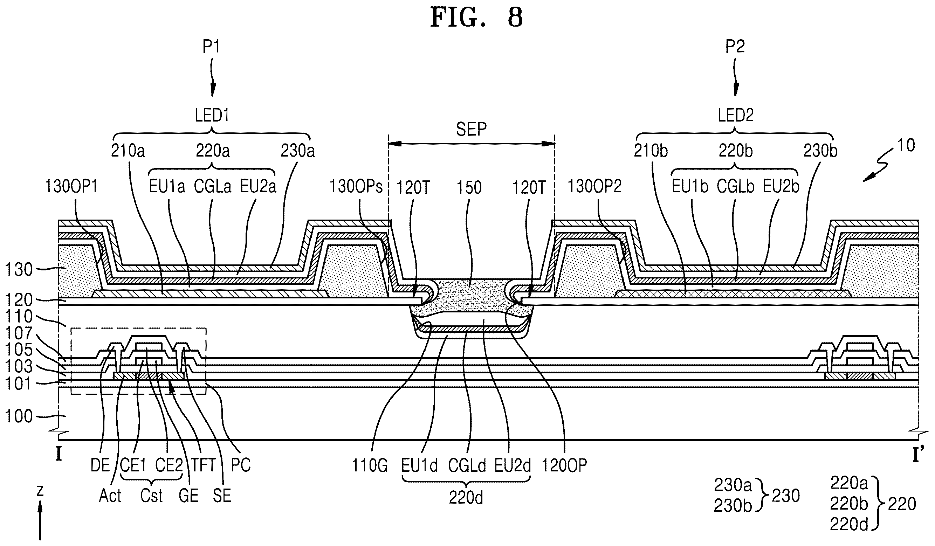

FIG. 8 is a schematic cross-sectional view of the display panel 10 according to an aspect, taken along line I-I' of FIG. 3A.

Referring to FIG. 8, the opposite electrode 230 may include a first opposite electrode 230a and a second opposite electrode 230b. That is, the first light-emitting diode LED1 may include the first pixel electrode 210a, the first intermediate layer 220a, and the first opposite electrode 230a, and the second light-emitting diode LED2 may include the second pixel electrode 210b, the second intermediate layer 220b, and the second opposite electrode 230b. In an aspect, the first opposite electrode 230a and the second opposite electrode 230b may be spaced apart from each other and may be electrically insulated.

In an aspect, each of the first opposite electrode 230a and the second opposite electrode 230b may not overlap the dummy intermediate layer 220d. In an aspect, each of the first opposite electrode 230a and the second opposite electrode 230b may be spaced apart from the dummy intermediate layer 220d.

The first opposite electrode 230a may be spaced apart from the portion of the first charge generation layer CGLa disposed on the tip 120T of the inorganic insulating layer 120. For example, the second opposite electrode 230b may be spaced apart from the portion of the second charge generation layer CGLb disposed on the tip 120T of the inorganic insulating layer 120.

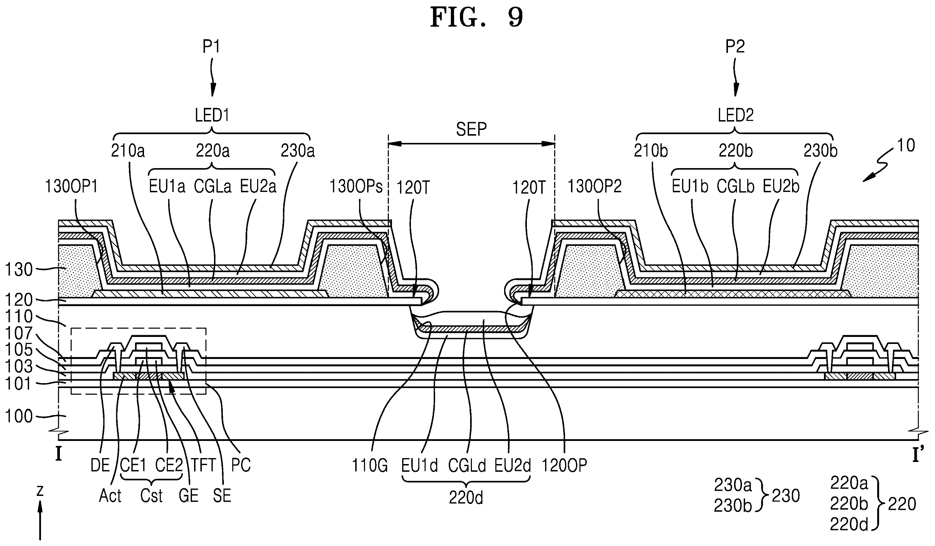

FIG. 9 is a schematic cross-sectional view of the display panel 10 according to an aspect, taken along line I-I' of FIG. 3A. In FIG. 9, redundant descriptions with reference to Fig. 8 are omitted, and only the differences are described.

Referring to FIG. 9, the intermediate insulating layer 150 is omitted, and the opposite electrode 230 may include the first opposite electrode 230a and the second opposite electrode 230b that are spaced apart from each other.

In the aspects of FIGS. 8 and 9, the first opposite electrode 230a and the second opposite electrode 230b are spaced apart from the first charge generation layer CGLa and the second charge generation layer CGLb, respectively, so that the first opposite electrode 230a may be electrically insulated from the first charge generation layer CGLa, and the second opposite electrode 230b may be electrically insulated from the second charge generation layer CGLb. Accordingly, current leakage between the first charge generation layer CGLa and the first opposite electrode 230a and current leakage between the second charge generation layer CGLb and the second opposite electrode 230b may be reduced or prevented.

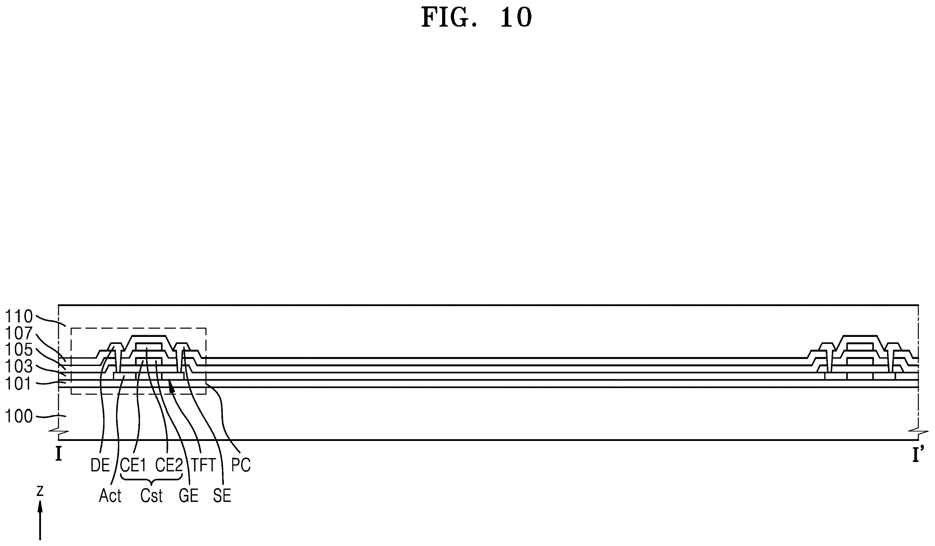

FIGS. 10 to 17 are sequential cross-sectional views illustrating a method of manufacturing the display panel 10, according to an aspect. FIGS. 10 to 17 sequentially illustrate, in cross-sectional views, the method of manufacturing the display panel 10 corresponding to the section described with reference to FIG. 5.

According to one or more aspects, a method of manufacturing a display panel may include forming an organic insulating layer on a transistor; forming an inorganic insulating layer on the organic insulating layer, the inorganic insulating layer including a first opening; removing a portion of the organic insulating layer, in a region overlapping the first opening of the inorganic insulating layer, to form a groove of the organic insulating layer and a tip of the inorganic insulating layer; forming a pixel electrode on the inorganic insulating layer; forming an intermediate layer on the pixel electrode, the intermediate layer including a first emission unit, a charge generation layer, and a second emission unit, and forming a dummy intermediate layer in the groove of the organic insulating layer; forming an intermediate insulating layer on the dummy intermediate layer; and forming an opposite electrode on the intermediate layer. In an aspect, the method of manufacturing the display panel may further include forming a pixel-defining layer disposed on the pixel electrode, the pixel-defining layer including a pixel opening exposing a portion of the pixel electrode and a separator opening connected to the first opening of the inorganic insulating layer and exposing the tip of the inorganic insulating layer.

FIG. 10 illustrates an operation of forming the pixel circuit PC including the transistor TFT on the substrate 100 and forming the organic insulating layer 110 on the transistor TFT.

Referring to FIG. 10, the pixel circuit PC including the transistor TFT may be formed on the substrate 100. For example, the buffer layer 101 may be formed on the substrate 100, and the pixel circuit PC including a transistor TFT and the capacitor Cst may be formed on the buffer layer 101. The transistor TFT may include the active layer Act, the gate electrode GE, the source electrode SE, and the drain electrode DE, and the capacitor Cst may include the first capacitor electrode CE1 and the second capacitor electrode CE2.

The active layer Act may be formed on the buffer layer 101. The gate insulating layer 103 may be formed on the active layer Act. The gate electrode GE may be formed on the gate insulating layer 103 to overlap the active layer Act in a plan view. The first interlayer insulating layer 105 may be formed on the gate electrode GE. The second capacitor electrode CE2 may be formed on the first interlayer insulating layer 105. At least a portion of the gate electrode GE may be formed to overlap the second capacitor electrode CE2 on a plane. For example, the gate electrode GE may function as the first capacitor electrode CE1 of the capacitor Cst. The second interlayer insulating layer 107 may be formed on the second capacitor electrode CE2. The source electrode SE and the drain electrode DE may be formed on the second interlayer insulating layer 107.

Each of the gate insulating layer 103, the first interlayer insulating layer 105, and the second interlayer insulating layer 107 may include an inorganic material such as silicon oxide, silicon nitride, and/or silicon oxynitride, and may be a multi-layer structure or single-layer structure including the above materials.

The organic insulating layer 110 is formed on the transistor TFT. For example, the organic insulating layer 110 may be formed on the second interlayer insulating layer 107. The organic insulating layer 110 may be a planarizing layer having a flat upper surface. The organic insulating layer 110 may include an organic insulating material. For example, the organic insulating layer 110 may include benzocyclobutene (BCB), polyimide, hexamethyldisiloxane (HMDSO), polymethylmethacrylate (PMMA), polystyrene, a polymer derivative having a phenol-based group, acryl-based polymer, imide-based polymer, arylether-based polymer, amide-based polymer, fluorine-based polymer, p-xylene-based polymer, vinyl alcohol-based polymer, or a compound thereof.

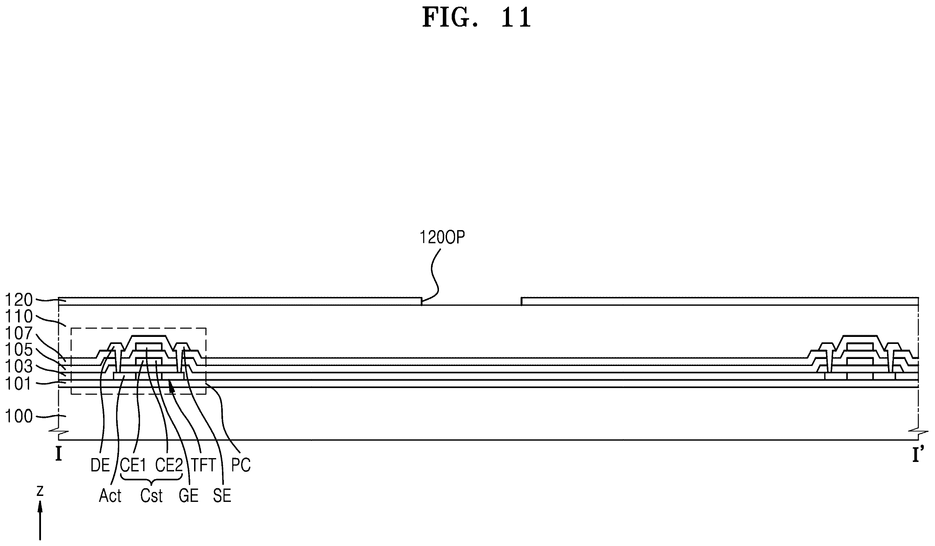

FIG. 11 illustrates an operation of forming the inorganic insulating layer 120 including the first opening 120OP on the organic insulating layer 110.

Referring to FIG. 11, the inorganic insulating layer 120 is formed on the organic insulating layer 110, and a portion of the inorganic insulating layer 120 may be removed to form the first opening 120OP. For example, an inorganic insulating material may be deposited on the organic insulating layer 110 to form the inorganic insulating layer 120, and the first opening 120OP of the inorganic insulating layer 120 may be formed by a dry etching process.

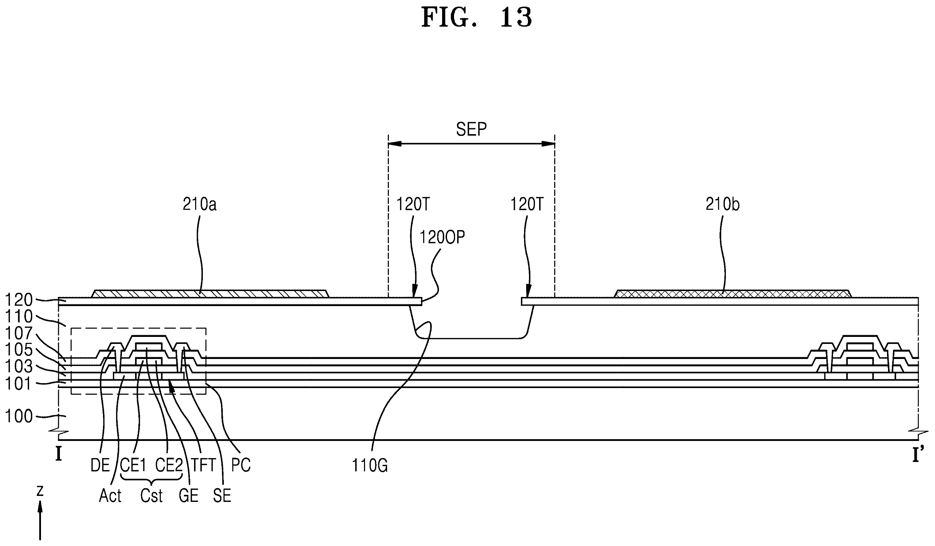

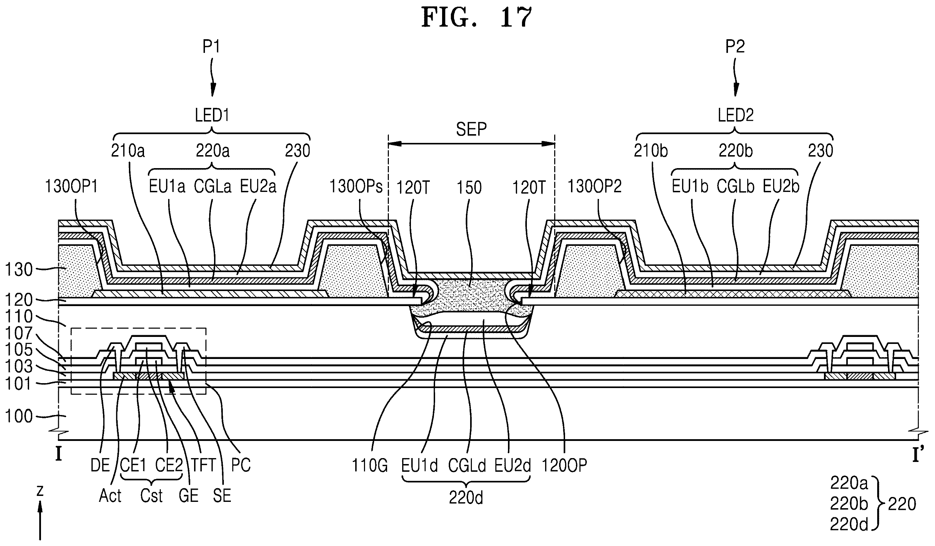

The first opening 120OP of the inorganic insulating layer 120 may be formed to be located between the first light-emitting diode LED1 (see FIG. 17) and the second light-emitting diode LED2 (see FIG. 17) described later. For example, the first opening 120OP of the inorganic insulating layer 120 may be formed to be located between the first pixel electrode 210a (see FIG. 13) and the second pixel electrode 210b (see FIG. 13) described later.

The inorganic insulating layer 120 may be formed of an inorganic insulating material such as, for example, silicon nitride (SiNₓ).

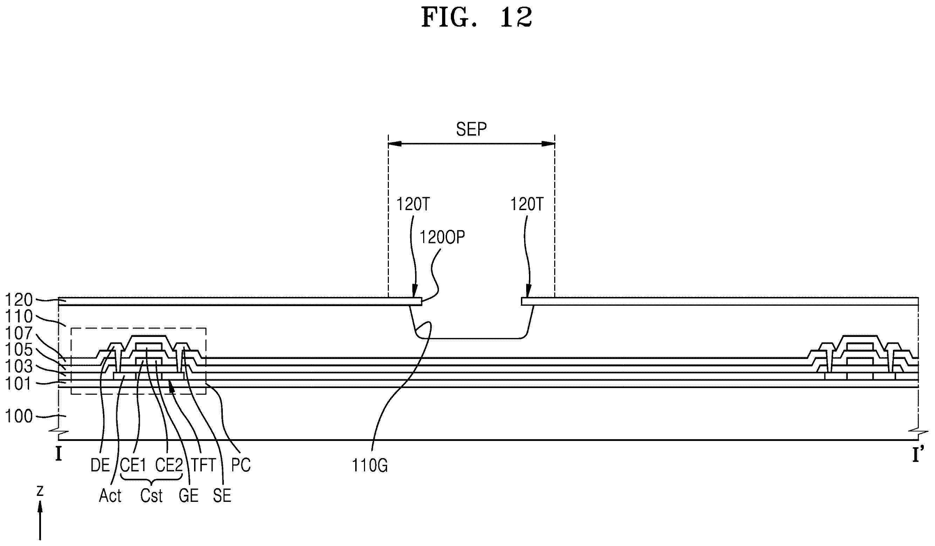

FIG. 12 illustrates an operation of forming the groove 110G of the organic insulating layer 110 and the tip 120T of the inorganic insulating layer 120 by removing a portion of the organic insulating layer 110 in an area overlapping the first opening 120OP of the inorganic insulating layer 120.

Referring to FIG. 12, a portion of the organic insulating layer 110 may be removed in an area overlapping the first opening 120OP of the inorganic insulating layer 120, so that the organic insulating layer 110 may have an undercut shape. That is, a portion of the organic insulating layer 110 exposed by the first opening 120OP of the inorganic insulating layer 120 is removed. The portion of the organic insulating layer 110 may be removed to have a side surface that is more deeply recessed than a side surface of the inorganic insulating layer 120 defining the first opening 120OP of the inorganic insulating layer 120, thereby forming the groove 110G of the organic insulating layer 110. For example, the portion of the organic insulating layer 110 may be removed by a dry etching process to form a groove 110G.

As the groove 110G of the organic insulating layer 110 is formed, the tip 120T of the inorganic insulating layer 120 may be formed that has a side surface that protrudes toward the center of the groove 110G of the organic insulating layer 110 more than the side surface of the organic insulating layer 110 defining the groove 110G of the organic insulating layer 110.

FIG. 13 illustrates an operation of forming the pixel electrode (e.g., the first pixel electrode 210a and the second pixel electrode 210b) on an inorganic insulating layer 120.

Referring to FIG. 13, the first pixel electrode 210a and the second pixel electrode 210b may be formed on the inorganic insulating layer 120. The first pixel electrode 210a and the second pixel electrode 210b may be formed to be spaced apart from each other. For example, the first pixel electrode 210a and the second pixel electrode 210b may be formed spaced apart from each other with the tip 120T of the inorganic insulating layer 120 and the groove 110G of the organic insulating layer 110 located between the first pixel electrode 210a and the second pixel electrode 210b.

Each of the first pixel electrode 210a and the second pixel electrode 210b may include a transparent conductive oxide such as indium tin oxide (ITO), indium zinc oxide (IZO), zinc oxide (ZnOₓ), indium oxide (In₂O₃), indium gallium oxide (IGO), indium gallium zinc oxide (IGZO), gallium zinc oxide (GZO), or aluminium zinc oxide (AZO). Each of the first pixel electrode 210a and the second pixel electrode 210b may include a reflective layer including silver (Ag), magnesium (Mg), aluminium (Al), platinum (Pt), palladium (Pd), gold (Au), nickel (Ni), neodymium (Nd), iridium (Ir), chromium (Cr), or a compound thereof. For example, each of the first pixel electrode 210a and the second pixel electrode 210b may have a three-layer structure of ITO/Ag/ITO.

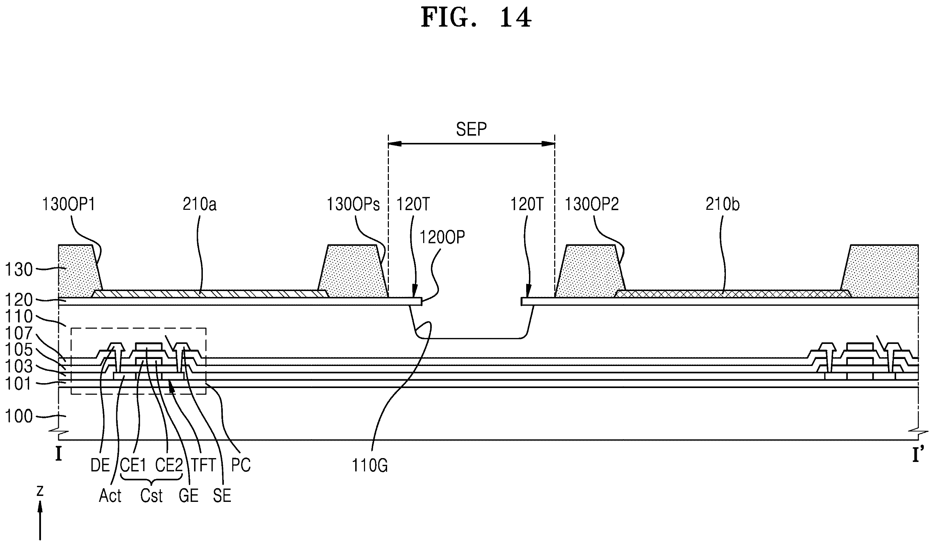

FIG. 14 illustrates an operation of forming the pixel-defining layer 130 disposed on the first pixel electrode 210a and the second pixel electrode 210b, the pixel-defining layer including the first pixel opening 130OP1 exposing a portion of the first pixel electrode 210a, the second pixel opening 130OP2 exposing a portion of the second pixel electrode 210b, and the separator opening 130OPs connected to the first opening 120OP of the inorganic insulating layer 120 and exposing a tip 120T of the inorganic insulating layer 120.

Referring to FIG. 14, the pixel-defining layer 130 may be formed on the first pixel electrode 210a and the second pixel electrode 210b. The first pixel opening 130OP1 that exposes a portion of the first pixel electrode 210a, the second pixel opening 130OP2 that exposes a portion of the second pixel electrode 210b, and the separator opening 130OPs that is connected to the first opening 120OP of the inorganic insulating layer 120 and exposes the tip 120T of the inorganic insulating layer 120 may be formed by removing portions of the pixel-defining layer 130.

The tip 120T of the inorganic insulating layer 120 and the groove 110G of the organic insulating layer 110 exposed by the separator opening 130OPs of the pixel-defining layer 130 may form the separator SEP.

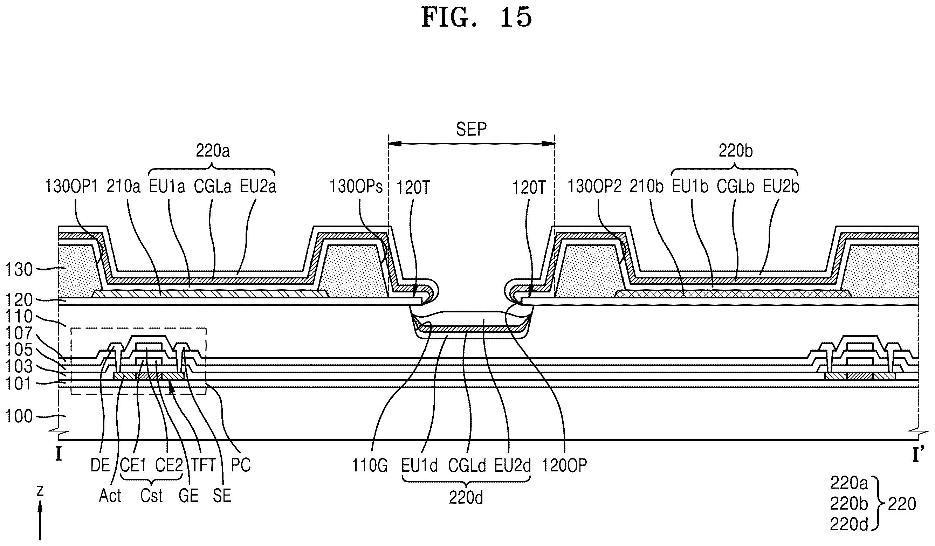

FIG. 15 illustrates an operation of forming the first intermediate layer 220a including the first-1 emission unit EU1a, the first charge generation layer CGLa, and the second-1 emission unit EU2a on the first pixel electrode 210a, and the second intermediate layer 220b including the first-2 emission unit EU1b, the second charge generation layer CGLb, and the second-2 emission unit EU2b on the second pixel electrode 210b, and forming the dummy intermediate layer 220d in the groove 110G of the organic insulating layer 110.

Referring to FIG. 15, the intermediate layer 220 may be formed on the first pixel electrode 210a, the second pixel electrode 210b, and the groove 110G of the organic insulating layer 110. The intermediate layer 220 may be separated into the first intermediate layer 220a, the second intermediate layer 220b, and the dummy intermediate layer 220d by the separator SEP. That is, the intermediate layer 220 may be separated into the first intermediate layer 220a, the second intermediate layer 220b, and the dummy intermediate layer 220d by the tip 120T of the inorganic insulating layer 120 and the groove 110G of the organic insulating layer 110. For example, the first intermediate layer 220a may be formed on the first pixel electrode 210a, the second intermediate layer 220b may be formed on the second pixel electrode 210b, and the dummy intermediate layer 220d may be formed in the groove 110G of the organic insulating layer 110 (or on the groove 110G).

The first-1 emission unit EU1a of the first intermediate layer 220a, the first-2 emission unit EU1b of the second intermediate layer 220b, and the first dummy layer EU1d of the dummy intermediate layer 220d may be formed to be separated and spaced apart by the separator SEP. Each of the first-1 emission unit EU1a of the first intermediate layer 220a, the first-2 emission unit EU1b of the second intermediate layer 220b, and the first dummy layer EU1d of the dummy intermediate layer 220d may include a same material. For example, each of the first-1 emission unit EU1a of the first intermediate layer 220a, the first-2 emission unit EU1b of the second intermediate layer 220b, and the first dummy layer EU1d of the dummy intermediate layer 220d may include the first-1 common layer 221-1, the first-2 common layer 221-2, and the second common layer 223 described with reference to FIG. 4.

The first-1 emission unit EU1a of the first intermediate layer 220a may include the first lower emission layer 222a (see FIG. 4), the first-2 emission unit EU1b of the second intermediate layer 220b may include the second lower emission layer 222b (see FIG. 4), and the first dummy layer EU1d of the dummy intermediate layer 220d may not include an emission layer. The first lower emission layer 222a (see FIG. 4) and the second lower emission layer 222b (see FIG. 4) may be formed in the first pixel opening 130OP1 and the second pixel opening 130OP2, respectively.

The second-1 emission unit EU2a of the first intermediate layer 220a, the second-2 emission unit EU2b of the second intermediate layer 220b, and the second dummy layer EU2d of the dummy intermediate layer 220d may be formed to be separated and spaced apart by the separator SEP. Each of the second-1 emission unit EU2a of the first intermediate layer 220a, the second-2 emission unit EU2b of the second intermediate layer 220b, and the second dummy layer EU2d of the dummy intermediate layer 220d may include a same material. Each of the second-1 emission unit EU2a of the first intermediate layer 220a, the second-2 emission unit EU2b of the second intermediate layer 220b, and the second dummy layer EU2d of the dummy intermediate layer 220d may include the third common layer 224, the fourth-1 common layer 227-1, and the fourth-2 common layer 227-2 described with reference to FIG. 4.

The second-1 emission unit EU2a of the first intermediate layer 220a may include the first upper emission layer 225a (see FIG. 4), the second-2 emission unit EU2b of the second intermediate layer 220b may include the second upper emission layer (225b, see FIG. 4), and the second dummy layer EU2d of the dummy intermediate layer 220d may not include an emission layer. The first upper emission layer 225a (see FIG. 4) and the second upper emission layer 225b (see FIG. 4) may be formed in the first pixel opening 130OP1 and the second pixel opening 130OP2, respectively.

The charge generation layer CGL (see FIG. 4) included in the intermediate layer 220 may be formed across the first light-emitting diode LED1 and the second light-emitting diode LED2, and may be separated and spaced apart by the separator SEP. For example, the first charge generation layer CGLa of the first intermediate layer 220a, the second charge generation layer CGLb of the second intermediate layer 220b, and the dummy charge generation layer CGLd of the dummy intermediate layer 220d may be formed to be separated by the separator SEP.

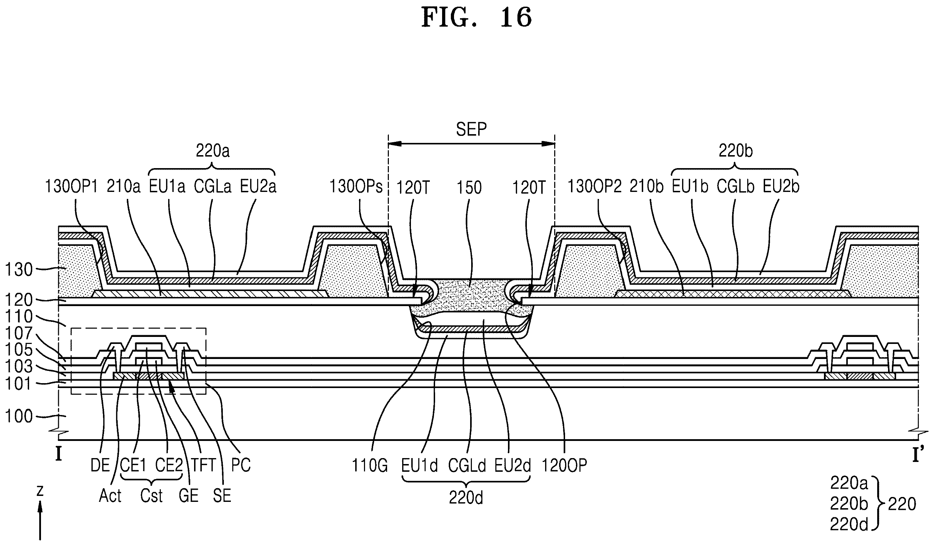

FIG. 16 illustrates an operation of forming the intermediate insulating layer 150 on the dummy intermediate layer 220d.

Referring to FIG. 16, the intermediate insulating layer 150 may be formed on the dummy intermediate layer 220d in the separator opening 130OPs. The intermediate insulating layer 150 may be formed to be located between the first light-emitting diode LED1 and the second light-emitting diode LED2. For example, the intermediate insulating layer 150 may be located between the first pixel electrode 210a and the second pixel electrode 210b. For example, the intermediate insulating layer 150 may be located between the first intermediate layer 220a and the second intermediate layer 220b.

In an aspect, at least a portion of the intermediate insulating layer 150 may be formed in the groove 110G of the organic insulating layer 110. In an aspect, at least a portion of the intermediate insulating layer 150 may be formed between the tip 120T of the inorganic insulating layer 120 and the dummy intermediate layer 220d. For example, the intermediate insulating layer 150 may be formed between a portion of the first intermediate layer 220a disposed on the tip 120T of the inorganic insulating layer 120 and the dummy intermediate layer 220d, and between a portion of the second intermediate layer 220b disposed on the tip 120T of the inorganic insulating layer 120 and the dummy intermediate layer 220d.

In an aspect, as illustrated with reference to FIG. 7, the intermediate insulating layer 150 may be formed to include the first intermediate insulating layer 150a1 and the second intermediate insulating layer 150a2 that are spaced apart from each other. At this time, at least a portion of the first intermediate insulating layer 150a1 may be formed to be located between the first intermediate layer 220a and the dummy intermediate layer 220d, and at least a portion of the second intermediate insulating layer 150a2 may be formed to be located between the second intermediate layer 220b and the dummy intermediate layer 220d.

The intermediate insulating layer 150 may be formed of an organic insulating material. For example, the intermediate insulating layer 150 may be formed by further including a black material (e.g., carbon black, carbon nanotubes, black pigment, or black dye).

FIG. 17 illustrates an operation of forming the opposite electrode 230 on the intermediate layer 220.

Referring to FIG. 17, the opposite electrode 230 may be formed on the first intermediate layer 220a and the second intermediate layer 220b. In an aspect, the opposite electrode 230 may be formed integrally across the first intermediate layer 220a and the second intermediate layer 220b. The opposite electrode 230 may be formed on the intermediate insulating layer 150. Each of the first charge generation layer CGLa and the second charge generation layer CGLb may be spaced apart from the opposite electrode 230 by the intermediate insulating layer 150. In an aspect, the portion of the first intermediate layer 220a disposed on the tip 120T of the inorganic insulating layer 120 and the portion of the second intermediate layer 220b disposed on the tip 120T of the inorganic insulating layer 120 may be formed to be in contact with the intermediate insulating layer 150.

In an aspect, as described with reference to FIGS. 8 and 9, the opposite electrode 230 may be formed to include the first opposite electrode 230a and the second opposite electrode 230b that are patterned and spaced apart from each other.

The display panel and the electronic apparatus including the same according to an aspect may improve display quality and reliability of the display panel. The above-described effects are exemplary, and the scope of the disclosure is not limited by these effects.

The present aspects have been described with reference to an aspect shown in the drawings, but this is merely an example, and one of ordinary skill in the art will understand that various modifications and variations of the aspect are possible therefrom. Therefore, the protection scope of the present aspects should be determined by the attached claims.

## Claims

1. A display panel (10) comprising:
a transistor (TFT) on a substrate (100);
an organic insulating layer (110) disposed on the transistor (TFT) and including a groove (110G);
an inorganic insulating layer (120) disposed on the organic insulating layer (110), the inorganic insulating layer (120) including a tip (120T) extending toward a center of the groove (110G);
a first pixel electrode (210a) and a second pixel electrode (210b), disposed on the inorganic insulating layer (120);
a first intermediate layer (220a) disposed on the first pixel electrode (210a);
a second intermediate layer (220b) disposed on the second pixel electrode (210b);
a dummy intermediate layer (220d) disposed in the groove (110G) of the organic insulating layer (110), the dummy intermediate layer (220d) separated from the first intermediate layer (220a) and the second intermediate layer (220b), wherein the first intermediate layer (220a), the second intermediate layer (220b) and the dummy intermediate layer (220d) have the same composition;
an intermediate insulating layer (150, 150a) disposed on the dummy intermediate layer (220d) and in contact with each of the first intermediate layer (220a) and the second intermediate layer (220b); and
an opposite electrode (230) disposed on the first intermediate layer (220a) and the second intermediate layer (220b).

2. The display panel (10) of claim 1, wherein
the first intermediate layer (220a) includes a first-1 emission unit (EU1a), a first charge generation layer (CGLa), and a second-1 emission unit (EU2a), and
the first charge generation layer (CGLa) is spaced apart from the opposite electrode (230) by the intermediate insulating layer (150, 150a), in a region overlapping the groove (110G) of the organic insulating layer (110).

3. The display panel (10) of claim 1 or claim 2, wherein
the intermediate insulating layer (150, 150a) is located between the first pixel electrode (210a) and the second pixel electrode (210b).

4. The display panel (10) of any one of claims 1 to 3, wherein
at least a portion of the intermediate insulating layer (150, 150a) is disposed between the dummy intermediate layer (220d) and the tip (120T) of the inorganic insulating layer (120).

5. The display panel (10) of any one of claims 1 to 4, wherein
at least a portion of the intermediate insulating layer (150, 150a) is disposed between the dummy intermediate layer (220d) and a portion of the first intermediate layer (220a) disposed on the tip (120T) of the inorganic insulating layer (120).

6. The display panel (10) of any one of claims 1 to 5, wherein
the intermediate insulating layer (150a) includes a first intermediate insulating layer (150a1) and a second intermediate insulating layer (150a2), wherein in a cross-section, at least a portion of the first intermediate insulating layer (150a1) is positioned between the first intermediate layer (220a) and the dummy intermediate layer (220d), and in a cross-section, at least a portion of the second intermediate insulating layer (150a2) is positioned between the second intermediate layer (220b) and the dummy intermediate layer (220d), and
the first intermediate insulating layer (150a1) and the second intermediate insulating layer (150a2) are spaced apart from each other.

7. The display panel (10) of any one of claims 1 to 6, wherein
a distance between an upper surface of the substrate (100) and an upper surface of the intermediate insulating layer (150, 150a) is greater than a distance between the upper surface of the substrate (100) and an upper surface of the inorganic insulating layer (120).

8. The display panel (10) of any one of claims 1 to 7, wherein
the intermediate insulating layer (150, 150a) includes an organic insulating material.

9. The display panel (10) of any one of claims 1 to 8, further comprising
a pixel-defining layer (130) disposed on the first pixel electrode (210a) and the second pixel electrode (210b), the pixel-defining layer (130) including a first pixel opening (130OP1) exposing a portion of the first pixel electrode (210a), a second pixel opening (130OP2) exposing a portion of the second pixel electrode (210b), and a separator opening (130OPs) aligned with the groove (110G) of organic insulating layer (110), optionally wherein
the intermediate insulating layer (150, 150a) is arranged within the separator opening (130OPs) of the pixel-defining layer (130).

10. The display panel (10) of any one of claims 1 to 9, wherein
the tip (120T) of the inorganic insulating layer (120) protrudes in a direction toward the center of the groove (110G) more than a side surface of the organic insulating layer (110) defining of the groove (110G).

11. The display panel (10) of any one of claims 1 to 10, wherein:
(i) the opposite electrode (230) is in contact with the intermediate insulating layer (150, 150a); or
(ii) the opposite electrode (230) includes: a first opposite electrode (230a) disposed on the first intermediate layer (220a); and a second opposite electrode (230b) disposed on the second intermediate layer (220b), and
the first opposite electrode (230a) and the second opposite electrode (230b) are spaced apart from each other.

12. An electronic apparatus (1) comprising:
a display module (11) including a display panel (10);
a power module (14);
a memory (13); and
a processor (12) configured to provide an image data signal and an input control signal to the display module (11),
wherein the display panel (10) is a display panel (10) of any one of claims 1 to 11.

13. A method of manufacturing a display panel (10), the method comprising:
forming an organic insulating layer (110) on a transistor (TFT);
forming an inorganic insulating layer (120) on the organic insulating layer (110), the inorganic insulating layer (120) including a first opening (120OP);
removing a portion of the organic insulating layer (110), in a region overlapping the first opening (120OP) of the inorganic insulating layer (120), to form a groove (110G) of the organic insulating layer (110) and a tip (120T) of the inorganic insulating layer (120);
forming a pixel electrode (210) on the inorganic insulating layer (120);
disposing an intermediate layer (220) on the pixel electrode (210) and on the groove (110G) so that the tip (120T) of the inorganic insulating layer (120) and the groove (110G) of the organic insulating layer (110) separates the intermediate layer (220) to form a dummy intermediate layer (220d) in the groove (110G), the intermediate layer (220) including a first emission unit (EU1), a charge generation layer (CGL), and a second emission unit (EU2);
forming an intermediate insulating layer (150) on the dummy intermediate layer (220d); and
forming an opposite electrode (230) on the intermediate layer (220).

14. The method of claim 13, wherein:
(i) after forming the opposite electrode (230), the charge generation layer (CGL) is spaced apart from the opposite electrode (230) by the intermediate insulating layer (150), in a region overlapping the groove (110G) of the organic insulating layer (110); and/or
(ii) the method further comprises
forming a pixel-defining layer (130) disposed on the pixel electrode (210), the pixel-defining layer (130) including a pixel opening (130OP1, 130OP2) exposing a portion of the pixel electrode (210) and a separator opening (130OPs) connected to the first opening (120OP) of the inorganic insulating layer (120) and exposing the tip (120T) of the inorganic insulating layer (120).

15. The method of claim 13 or claim 14, wherein:
(i) the intermediate insulating layer (150) includes an organic insulating material; or
(ii) the intermediate insulating layer (150) includes a black organic insulating material.
